# EUROPEAN PATENT APPLICATION

(11) **EP 4 289 791 A1**
(43) Date of publication of application: **13.12.2023**
(21) Application number: 22749579.3
(22) Date of filing: 26.01.2022
(51) Int. Cl.: C01G 45/00, C09K 11/64, C09K 11/80, F21Y 115/10, F21Y 115/15, H01L 33/50, F21V 9/30, G02B 5/20

(54) **PHOSPHOR AND METHOD FOR PRODUCING PHOSPHOR**

(30) Priority: 05.02.2021 JP 2021017631
(71) Applicant: Sumitomo Chemical Company Limited, Tokyo 103-6020 (JP)
(72) Inventor: ARIMURA, Takashi, Niihama-shi, Ehime 792-8521 (JP); KANNAMI, Masaki, Niihama-shi, Ehime 792-8521 (JP); NAITO, Shota, Niihama-shi, Ehime 792-8521 (JP); IWASAKI, Kentaro, Niihama-shi, Ehime 792-8521 (JP); SASAKI, Shinichi, Niihama-shi, Ehime 792-8521 (JP)
(74) Representative: Vossius & Partner Patentanwälte Rechtsanwälte mbB
(86) International application number: PCT/JP2022/002866
(87) International publication number: WO 2022/168705

(57) **Abstract**

A phosphor including a crystal phase of an aluminate compound containing a metal element M constituting a luminescent center ion and aluminum, in which the crystal phase contains crystallites, and an average size of the crystallites is 2 to 100 µm.

## Description

### TECHNICAL FIELD

The present invention relates to a phosphor used in a light emitting device or the like, and particularly, to a phosphor having excellent light emission intensity.

### BACKGROUND ART

Patent Document 1 describes an MgAl₂O₄-based spinel-type oxide fluorescent emitter doped with Mn that can be used as a red light emitting phosphor. The phosphor of Patent Document 1 contains an excessive amount of Mg. An MgAl₂O₄-based oxide fluorescent emitter having a doped amount of Mn within a specific range and an excessive amount of Mg can emit high brightness red light.

Patent Document 2 describes that a γ-AlON-based green light emitting phosphor having high brightness can be obtained by defining a range of a specific surface area obtained by a gas absorption method in the γ-AlON-based green light emitting phosphor in which Mn and Mg are solid-solved in a host crystal having the same crystal structure as that of a cubic spinel-type AlON crystal. Patent Document 3 describes, as a specific example, a phosphor having a composition represented by a formula Mn_{0.15}Mg_{0.54}Al_{3.0}O_{4.4}N_{0.54} [a molar ratio is calculated as Al = 3.0].

Patent Document 3 describes that an oxynitride in which a metal element constituting a metal ion such as Mn is solid-solved in an AlON crystal has a specific composition range, a specific solid solution state, and a specific crystal phase, such that a blue phosphor having a light emission peak in a wavelength range of 300 nm or more and 700 nm or less is obtained. Patent Document 3 describes, as a specific example, a phosphor having a composition represented by a formula Mn_{0.07-0.28}Al_{2.1}O_{2.8-3.1}N_{0.3} [a molar ratio is calculated as Al = 2.1].

Patent Document 4 describes an α-sialon phosphor obtained by firing, crushing, and classifying a raw material mixed powder, in which the powder has a bulk density of 1.00 g/cm³ or more and 1.80 g/cm³ or less. The bulk density of the α-sialon phosphor of Patent Document 4 is controlled in a specific range, such that it is possible to reduce a variation in chromaticity of a light emitting element, for example, a white LED, produced using the phosphor.

Patent Document 5 describes a β-sialon phosphor obtained by firing a raw material mixed powder, mixing a powder of the obtained fired product with alkoxysilane, and dehydrating and condensing the powder of the fired product and the alkoxysilane, in which an average particle diameter D50 of the β-sialon phosphor is 1.2 times or more an average particle diameter D50 of the powder of the fired product of the raw material mixed powder.

In the β-sialon phosphor of Patent Document 5, relatively small particles that do not cause a decrease in internal quantum efficiency are combined with each other, such that an apparent particle diameter is increased to improve light emission efficiency and also to improve dispersibility in a sealing resin so that high brightness can be exhibited even when the β-sialon phosphor is used as a light emitting element or a light emitting device.

### PRIOR ART DOCUMENTS

### PATENT DOCUMENTS

Patent Document 1: JP-A-2016-17125
Patent Document 2: JP-A-2018-109080
Patent Document 3: WO 2007/053324 A
Patent Document 4: WO 2019/011619 A
Patent Document 5: JP-A-2019-104773

### SUMMARY OF THE INVENTION

### PROBLEMS TO BE SOLVED BY THE INVENTION

Conventionally, a phosphor using crystals of an inorganic compound has been improved in light emission intensity by optimizing an element composition or a particle size. However, when the phosphor is used in a light emitting device such as a white LED, it is required to further improve the light emission intensity.

The present invention solves the above problems, and an object thereof is to provide a phosphor having excellent light emission intensity or a method for producing a phosphor.

### MEANS FOR SOLVING THE PROBLEMS

The present invention provides a phosphor containing a crystal phase of an aluminate compound containing a metal element M constituting a luminescent center ion and aluminum,
in which the crystal phase contains crystallites, and
an average size of the crystallites is 2 to 100 µm.

In addition, the present invention provides a phosphor containing a crystal phase of an aluminate compound having an element composition represented by Formula:

MₓMgₐSi_{b}Al_{y}O_{z}N_{w} (1)

[in Formula (1), M represents at least one metal element selected from the group consisting of manganese, strontium, cerium, praseodymium, neodymium, samarium, europium, gadolinium, terbium, dysprosium, thulium, and ytterbium, x is 0.001 ≤ x ≤ 0.3, a is 0 ≤ a ≤ 1.0 - x, b is 0 ≤ b ≤ 6.0, y is 0 ≤ y ≤ 11.3, z is 0 ≤ z ≤ 18, and w is 0 ≤ w ≤ 8.0],
in which the crystal phase contains crystallites, and
an average size of the crystallites is 2 to 100 µm.

In addition, the present invention provides a phosphor containing a crystal phase of a magnesia-alumina spinel compound having an element composition represented by Formula:

MₓMgₐAl_{y}O_{z}N_{w} (2)

[in Formula (2), M represents at least one metal element selected from the group consisting of manganese, strontium, cerium, praseodymium, neodymium, samarium, europium, gadolinium, terbium, dysprosium, thulium, and ytterbium, x is 0.001 ≤ x ≤ 0.3, a is 0 ≤ a ≤ 1.0 - x, y is 1.2 ≤ y ≤ 11.3, z is 2.8 ≤ z ≤ 18, and w is 0 ≤ w ≤ 1.0],
in which the crystal phase contains crystallites, and
an average size of the crystallites is 2 to 100 µm.

In addition, the present invention provides a phosphor containing a crystal phase of a magnesia-alumina spinel compound having an element composition represented by Formula:

MₓMg₍₁₋ₓ₎Al_{y}O_{z} (3)

[in Formula (3), M represents at least one metal element selected from the group consisting of manganese, strontium, cerium, praseodymium, neodymium, samarium, europium, gadolinium, terbium, dysprosium, thulium, and ytterbium, x is 0.001 ≤ x ≤ 0.3, y is 1.2 ≤ y ≤ 11.3, and z is 2.8 ≤ z ≤ 18],
in which the crystal phase contains crystallites, and
an average size of the crystallites is an average particle diameter of 2 to 100 µm.

In addition, the present invention provides a phosphor containing a crystal phase of a β-sialon compound having an element composition represented by Formula:

MᵤSi₆₋ᵥAlᵥOᵥN₈₋ᵥ (4)

[in Formula (4), M represents at least one metal element selected from the group consisting of manganese, cerium, praseodymium, neodymium, samarium, europium, gadolinium, terbium, dysprosium, thulium, and ytterbium, u is 0.001 ≤ u ≤ 0.3, and v is 0 < v < 4.2],
in which the crystal phase contains crystallites, and
an average size of the crystallites is an average particle diameter of 2 to 100 µm.

In one embodiment, the metal element M constituting the luminescent center ion represents at least one metal element selected from the group consisting of manganese, strontium, europium, and terbium.

In one embodiment, in Formula (1), x is 0.001 ≤ x ≤ 0.15, a is 0 ≤ a ≤ 0.95, b is 0 ≤ b ≤ 6.0, y is 0 ≤ y ≤ 2.5, z is 0 ≤ z ≤ 4.5, and w is 0 ≤ w ≤ 1.0.

In one embodiment, in Formula (2) or (3), x is 0.05 ≤ x ≤ 0.15, a is 0 ≤ a ≤ 0.95, y is 1.5 ≤ y ≤ 2.5, z is 3.5 ≤ z ≤ 4.5, and w is 0 ≤ w ≤ 1.0.

In one embodiment, in Formula (4), u is 0.001 ≤ u ≤ 0.02 and v is 0.005 ≤ v ≤ 1.0.

In one embodiment, the crystallites of the crystal phase in Formula (2) or (3) have a spinel-type crystal structure.

In one embodiment, any one of the phosphors has a core-shell structure that includes:
a core part formed of the crystal phase; and
a shell part containing at least one element selected from the group consisting of boron and silicon and formed on at least a portion of a surface of the core part.

In one embodiment, any one of the phosphors has D50 in a particle diameter distribution of 1 to 500 µm.

In addition, the present invention provides a film including any one of the phosphors.

In addition, the present invention provides a light emitting element including any one of the phosphors.

In addition, the present invention provides a light emitting device including the light emitting element.

In addition, the present invention provides a display including the light emitting element.

In addition, the present invention provides a sintered body including any one of the phosphors.

In addition, the present invention provides a phosphor wheel including any one of the phosphors.

In addition, the present invention provides a projector using the phosphor wheel.

In addition, the present invention provides a method for producing a phosphor having the core-shell structure, the method including:
mixing a raw material of a crystal phase in which the amount of each of M, Mg, Si, Al, O, and N is adjusted to a predetermined molar ratio and a raw material of a shell part containing at least one element selected from the group consisting of boron and silicon to obtain a mixture; and
heating the obtained mixture at a temperature at which the raw material of the shell part is liquefied, but a host crystal of phosphor is maintained to be obtained.

In one embodiment, the raw material of the crystal phase contains a raw material compound having a specific surface area of 0.01 to 15 m²/g and containing aluminum.

In one embodiment, the raw material of the crystal phase contains a raw material compound having D50 in a particle diameter distribution of 0.2 to 90 um and containing aluminum.

### EFFECT OF THE INVENTION

According to the present invention, there is provided a phosphor having excellent light emission intensity or a method for producing a phosphor.

### MODE FOR CARRYING OUT THE INVENTION

### <Phosphor>

A phosphor is generally formed of a crystal of an inorganic compound containing rare earth ions or the like. The phosphor of the present invention contains a crystal phase of an inorganic compound containing a metal element M constituting a luminescent center ion and aluminum.

The inorganic compound is preferably an aluminate compound. The aluminate is represented by a composition formula: xMO·yAl₂O₃ (in the formula, M is a metal such as an alkaline earth metal). By introducing a plurality of divalent metals as the metal M or doping an M site with a rare earth metal, Mn, or the like as an activator, a phosphor having various compositions is produced. In the present specification, the aluminate compound refers to an inorganic compound containing an aluminate as a base structure.

In one embodiment of the present invention, the aluminate compound has an element composition represented by Formula:

MₓMgₐSi_{b}Al_{y}O_{z}N_{w} (1)

[in Formula (1), M represents a metal element constituting the luminescent center ion, and x, a, b, y, z, and w represent composition ratios of the element]. In the present specification, the composition ratio means a molar ratio.

Examples of the metal element M include at least one metal element selected from the group consisting of manganese, strontium, cerium, praseodymium, neodymium, samarium, europium, gadolinium, terbium, dysprosium, thulium, and ytterbium, at least one metal element selected from the group consisting of manganese, strontium, europium, and terbium is preferable, and at least one metal element selected from the group consisting of manganese and europium is more preferable.

The composition ratio x of the metal element M is 0.001 ≤ x ≤ 0.3, and preferably 0.01 ≤ x ≤ 0.15. When x is less than 0.001, the amount of the metal element M constituting the luminescent center ion is small, and the light emission intensity is likely to decrease. In addition, when x is more than 0.3, the light emission intensity is likely to decrease due to an interference phenomenon between metal elements M called concentration quenching.

The composition ratio a of Mg is 0 ≤ a ≤ 1.0 - x, and preferably 0 ≤ a ≤ 0.95. The composition ratio b of Si is 0 ≤ b ≤ 6.0.

The composition ratio y of Al is 0 ≤ y ≤ 11.3, and preferably 0 ≤ y ≤ 2.5. The composition ratio z of O is 0 ≤ z ≤ 18, and preferably 0 ≤ z ≤ 4.5. The composition ratio w of N is 0 ≤ w ≤ 8.0, and preferably 0 ≤ w ≤ 1.0. When the composition ratios y, z, and w are not within these ranges, a host crystal of the phosphor has an unstable structure, and a quenching process increases, such that the light emission intensity is likely to decrease.

In one embodiment, the composition ratio a of Mg is 0.1 ≤ a ≤ 0.99, for example, 0.3 ≤ a ≤ 0.98, preferably 0.5 ≤ a ≤ 0.97, more preferably 0.7 ≤ a ≤ 0.97, still more preferably 0.8 ≤ a ≤ 0.96, and particularly preferably 0.85 ≤ a ≤ 0.96,
the composition ratio b of Si is 0 ≤ b ≤ 4.0, for example, 0 ≤ b ≤ 2.0, preferably 0 ≤ b ≤ 1.0, more preferably 0 ≤ b ≤ 0.5, still more preferably 0 ≤ b ≤ 0.2, and particularly preferably 0 ≤ b ≤ 0.1,
the composition ratio y of Al is 1.25 ≤ y ≤ 10.3, for example, 1.35 ≤ y ≤ 7.0, preferably 1.45 ≤ y ≤ 3.5, more preferably 1.65 ≤ y ≤ 2.4, still more preferably 1.85 ≤ y ≤ 2.3, and particularly preferably 1.95 ≤ y ≤ 2.2,
the composition ratio z of O is 2.9 ≤ z ≤ 15.0, for example, 3.15 ≤ z ≤ 10.5, preferably 3.4 ≤ z ≤ 6.5, more preferably 3.6 ≤ z ≤ 5, and still more preferably 3.7 ≤ z ≤ 4.5, and
the composition ratio w of N is 0 ≤ w ≤ 1.0, for example, 0 ≤ w ≤ 0.5, preferably 0 ≤ w ≤ 0.2, more preferably 0 ≤ w ≤ 0.1, still more preferably 0 ≤ w ≤ 0.01, and particularly preferably 0 ≤ w ≤ 0.005.

An upper limit and a lower limit of a numerical value of each of x, a, y, z, and w can be appropriately combined and selected from the values of the ranges in order to obtain a desired phosphor.

Here, when the composition ratio b of Si in Formula (1) is 0, the aluminate compound is a magnesia-alumina spinel compound. In a preferred embodiment of the present invention, the aluminate compound is a magnesia-alumina spinel compound. The magnesia-alumina spinel compound has an element composition represented by Formula:

MₓMgₐAl_{y}O_{z}N_{w} (2)

[in Formula (2), M represents a metal element constituting the luminescent center ion, and x, a, y, z, and w represent composition ratios of the element].

Examples of the metal element M include at least one metal element selected from the group consisting of manganese, strontium, cerium, praseodymium, neodymium, samarium, europium, gadolinium, terbium, dysprosium, thulium, and ytterbium, at least one metal element selected from the group consisting of manganese, strontium, europium, and terbium is preferable, at least one metal element selected from manganese and strontium is more preferable, and manganese is still more preferable.

When the metal element M is manganese, manganese constitutes the luminescent center ion, and a green light emitting phosphor that emits green light can be obtained.

When the phosphor is irradiated with excitation light, the luminescent center ion contained in the phosphor absorbs the excitation light, and electrons at a ground level transition to an excitation level. When the excited electrons return from the excitation level to the ground level again, energy corresponding to a difference in energy level is emitted as fluorescence. The transition probability of electrons from the ground level to the excitation level varies depending on an electron arrangement of the luminescent center ion, and in a case of a forbidden transition having a small transition probability, the absorbance is small and the light emission intensity is apparently small. On the other hand, in a case of an allowable transition having a large transition probability, the absorbance is large and the light emission intensity is apparently large.

Divalent manganese (Mn²⁺) has five electrons in the 3d orbital, and the transition to the excitation level by light irradiation is a forbidden transition because it is between the same orbitals (d-d), and the absorbance is small and the light emission intensity is also small. On the other hand, for example, divalent europium (Eu²⁺) has seven electrons in the 4f orbital, and the transition to the excitation level by light irradiation is an allowable transition because it is between the different orbitals (f-d), and the absorbance is large and the light emission intensity is also large.

The light emission intensity of the compound varies depending on the absorbance (the number of absorbed photons) of the compound. When the light emission intensity is compared between compounds having different absorbances as in a case of comparing a compound in which the metal element M is manganese and a compound in which the metal element M is europium, it is inappropriate to compare the light emission intensity to determine the superiority or inferiority of the light emission characteristics. The light emission characteristics of the compounds having different absorbances can be appropriately compared, for example, by using the light emission intensity in which the difference in absorbance is corrected, that is, the quantum efficiency.

Definition: "Quantum efficiency (Quantum yield) = Light emission intensity (Number of fluorescent photons)/Absorbance (Number of absorbed photons)"

In a preferred embodiment, the phosphor of the present invention exhibits an excitation wavelength around 450 nm. By exciting the phosphor at an excitation wavelength of 450 nm, a green light emission spectrum having a light emission peak in a wavelength range of 510 nm to 550 nm can be obtained. From the viewpoint of improving color purity of light emission, a half-value width of the light emission peak is preferably less than 50 nm, more preferably 45 nm or less, still more preferably 40 nm or less.

The composition ratio x of the metal element M is 0.001 ≤ x ≤ 0.3, for example, 0.005 ≤ x ≤ 0.3, preferably 0.01 ≤ x ≤ 0.2, more preferably 0.02 ≤ x ≤ 0.15, still more preferably 0.03 ≤ x ≤ 0.1, and particularly preferably 0.04 ≤ x ≤ 0.08. When x is less than 0.001, the amount of the metal element M constituting the luminescent center ion is small, and the light emission intensity is likely to decrease. In addition, when x is more than 0.3, the light emission intensity is likely to decrease due to an interference phenomenon between metal elements M called concentration quenching. The composition ratio a of Mg is 0 ≤ a ≤ 1.0 - x.

The composition ratio y of Al is 1.2 ≤ y ≤ 11.3, for example, 1.3 ≤ y ≤ 8.5, preferably 1.4 ≤ y ≤ 5.5, more preferably 1.5 ≤ y ≤ 2.5, and particularly preferably 1.5 ≤ y ≤ 2.3. The composition ratio z of O is 2.8 ≤ z ≤ 18, for example, 3.0 ≤ z ≤ 13.0, preferably 3.3 ≤ z ≤ 8.5, more preferably 3.4 ≤ z ≤ 5, and particularly preferably 3.5 ≤ z ≤ 4.5. The composition ratio w of N is 0 ≤ w ≤ 1.0, for example, 0 ≤ w ≤ 0.5, preferably 0 ≤ w ≤ 0.2, more preferably 0 ≤ w ≤ 0.1, still more preferably 0 ≤ w ≤ 0.01, and most preferably 0 ≤ w ≤ 0.005. When the composition ratios y, z, and w are not within these ranges, a host crystal of the phosphor has an unstable structure, and a quenching process increases, such that the light emission intensity is likely to decrease.

In one embodiment, the composition ratio a of Mg is 0.1 ≤ a ≤ 0.99, for example, 0.3 ≤ a ≤ 0.98, preferably 0.5 ≤ a ≤ 0.97, more preferably 0.7 ≤ a ≤ 0.97, still more preferably 0.8 ≤ a ≤ 0.96, and particularly preferably 0.85 ≤ a ≤ 0.96,
the composition ratio y of Al is 1.25 ≤ y ≤ 10.3, for example, 1.35 ≤ y ≤ 7.0, preferably 1.45 ≤ y ≤ 3.5, more preferably 1.65 ≤ y ≤ 2.4, still more preferably 1.85 ≤ y ≤ 2.3, and particularly preferably 1.95 ≤ y ≤ 2.2,
the composition ratio z of O is 2.9 ≤ z ≤ 15.0, for example, 3.15 ≤ z ≤ 10.5, preferably 3.4 ≤ z ≤ 6.5, more preferably 3.6 ≤ z ≤ 5, and still more preferably 3.7 ≤ z ≤ 4.5, and
the composition ratio w of N is, for example, 0.0005 ≤ w ≤ 0.01, and preferably 0.001 ≤ w ≤ 0.004.

An upper limit and a lower limit of a numerical value of each of x, a, y, z, and w can be appropriately combined and selected from the values of the ranges in order to obtain a desired phosphor.

The magnesia-alumina spinel compound preferably has an element composition represented by Formula:

MxMg₍₁₋ₓ)Al_{y}O_{z} (3)

[in the formula, M, x, y, and z have the same meaning as described above].

In addition, when the composition ratio a of Mg in Formula (1) is 0, the aluminate compound is a sialon compound. The sialon (SiAlON) compound refers to a solid solution obtained by substituting silicon (Si) and nitrogen (N) of silicon nitride (Si₃N₄) with aluminum (Al) and oxygen (O). A phosphor can be prepared by subjecting, to solid solution, a light emitting element such as a rare earth element in a crystal of a sialon compound. Among sialon phosphors, an α-sialon phosphor and a β-sialon phosphor are phosphors that have excellent temperature characteristics, are excellent in durability, and can be excited in blue.

The α-sialon phosphor is a solid solution of α-type silicon nitride, and has a structure in which specific elements (Ca and lanthanide metals excluding Li, Mg, Y or La and Ce) penetrate and are solid-solved between crystal lattices, and a Si-N bond is partially substituted with an Al-N bond and an Al-O bond in order to maintain electrical neutrality. When some of the penetrating solid solution elements are rare earth elements as a light emission center, fluorescence characteristics are exhibited.

The α-sialon phosphor is obtained by firing a mixed powder containing silicon nitride, aluminum nitride, and as necessary, aluminum oxide, oxides of penetrating solid solution elements, and the like at a high temperature in nitrogen. Various fluorescence characteristics can be obtained depending on the ratio of silicon nitride and the aluminum compound, the type of the penetrating solid solution element, the proportion of the element to be the luminescent center, and the like.

The β-sialon phosphor is a solid solution of β-type silicon nitride, and is obtained by substituting Al at the Si position and O at the N position of β-type silicon nitride. In general, as a raw material, in addition to silicon nitride, silicon oxide and aluminum nitride, or aluminum oxide and aluminum nitride are added and heated to obtain a β-sialon phosphor.

In a preferred embodiment of the present invention, the aluminate compound is a β-sialon phosphor. The β-sialon phosphor has an element composition represented by Formula:

MᵤSi₆₋ᵥAlᵥOᵥN₈₋ᵥ (4)

[in Formula (4), M represents a metal element constituting the luminescent center ion, and u and v represent composition ratios of the element].

Examples of the metal element M include at least one metal element selected from the group consisting of manganese, strontium, cerium, praseodymium, neodymium, samarium, europium, gadolinium, terbium, dysprosium, thulium, and ytterbium, at least one metal element selected from the group consisting of manganese, strontium, europium, and terbium is preferable, and at least one metal element selected from manganese and europium is more preferable.

The composition ratio u of the metal element M is 0.001 ≤ u ≤ 0.3, and preferably 0.001 ≤ u ≤ 0.02. When u is less than 0.001, the amount of the metal element M constituting the luminescent center ion is small, and the light emission intensity is likely to decrease. In addition, when u is more than 0.3, the light emission intensity is likely to decrease due to an interference phenomenon between metal elements M called concentration quenching.

The composition ratio v of Al and O is 0 ≤ v ≤ 4.2, and preferably 0.005 ≤ v ≤ 1.0. When the composition ratio v is not within these ranges, the host crystal of the phosphor has an unstable structure, and a quenching process increases, such that the light emission intensity is likely to decrease.

In one embodiment, the composition ratio u of M is 0.01 ≤ u ≤ 0.03, and the composition ratio v of Al and O is 0.1 ≤ v ≤ 0.3.

An upper limit and a lower limit of a numerical value of each of u and v can be appropriately combined and selected from the values of the ranges in order to obtain a desired phosphor.

The phosphor of the present invention is a sintered body particle obtained by heating a raw material. The sintered body particle contains a crystal phase. The crystal phase is a solid phase in which atoms are regularly arranged. On the other hand, a phase that is not a crystal phase is an amorphous state in which atoms are not regularly arranged. By analyzing the phosphor by X-ray structural diffraction and detecting an ordered arrangement of atoms, it can be confirmed that the phosphor contains a crystal phase.

The crystal phase contains crystallites formed of a single crystal. The phosphor, which is a sintered body particle, is generally a polycrystalline body. In such a case, the crystal phase of the phosphor contains a plurality of crystallites, and the crystal phase is formed by, for example, gathering the plurality of crystallites.

It is found that the light emission intensity of the phosphor is improved by increasing the size of the crystallite. When the size of the crystallite is increased, an area of an interface between the crystallites decreases. As a result, it is considered that reflection and/or scattering of light at a grain boundary of the crystallites is suppressed, and the light emission intensity is improved.

The effect of improving the light emission intensity of the phosphor by increasing the size of the crystallite is due to a mechanism of improving the efficiency of the generated light to exit to the outside of the crystallite. This mechanism does not increase the amount of light generated by optimizing the element composition of the crystal phase. Therefore, it is considered that the effect of the present invention is achieved regardless of the element composition of the crystal phase.

That is, all of the aluminate compound having the element composition represented by Formula (1), the magnesia-alumina spinel compound having the element composition represented by Formula (2) or (3), the α-sialon phosphor, and the β-sialon phosphor represented by Formula (4), which are specifically described in the present specification, can be phosphors that achieve the effect of improving the light emission intensity by increasing the crystallite size.

An average size of the crystallites contained in the phosphor is, for example, 2 um to 100 um, preferably 3 um to 80 µm, more preferably 4 µm to 50 µm, and still more preferably 5 um to 30 um. When the average size of the crystallites is smaller than 2 um, the improvement of the light emission intensity is insufficient, and when the average size of the crystallites is larger than 100 um, it is difficult to use as a raw material of a member such as a film and an element.

The average size of the crystallites can be determined by observing a cross section of the phosphor. That is, the size of the crystallite is determined by observing the cross section of the phosphor and analyzing the image of the crystallite observed therein. The size here means an equivalent circle diameter.

First, the phosphor is processed to obtain a cross section of the phosphor. Examples of a method for obtaining the cross-section of the phosphor include a method of processing with a focused ion beam (FIB) processing apparatus, a method of processing with an ion milling apparatus, and a method of processing by polishing. Since damage to a sample is small and a processing position can be accurately determined, the method of processing with an FIB processing apparatus is preferable from the viewpoint of easily obtaining a highly accurate image.

The cross section of the phosphor obtained by the processing is observed with an electron microscope. Examples of the electron microscope include a transmission electron microscope (TEM), a scanning electron microscope (SEM), and a scanning transmission electron microscope (STEM). Since a spatial resolution is high, a method of observing with a TEM is preferable from the viewpoint of easily obtaining an image with high accuracy.

When the cross section of the phosphor obtained by the processing is irradiated with an electron beam, a degree of scattering of electrons changes depending on the arrangement of atoms, such that a contrast of the acquired TEM image changes for each crystallite. As such, each crystallite is recognized. When the contrast of the TEM image is weak, an electron diffraction (ED) pattern is acquired in order to more accurately recognize the crystallite. The electron diffraction pattern represents information on the arrangement of atoms, and when this pattern is equivalent, it is recognized that the arrangement of atoms is equivalent, that is, the crystallites are the same.

The obtained TEM image is taken into a computer, and an equivalent circle diameter of one crystallite is calculated. The equivalent circle diameter is calculated by an area weighted average of one crystallite defined by the above method. Note that the equivalent circle diameter refers to a diameter of a perfect circle corresponding to the area of the corresponding region. Image analysis software may be used to calculate the equivalent circle diameter. Image J, Photoshop, or the like can be appropriately selected as the image analysis software.

Note that in the calculation of an average size of the crystallites using this method, it is preferable to analyze 50 or more crystallites and use an average equivalent circle diameter using the average value from the viewpoint of improving accuracy.

In a preferred embodiment of the phosphor of the present invention, the crystallite has a spinel-type crystal structure. The spinel-type crystal structure is a crystal structure belonging to a cubic crystal system, and is represented by a chemical formula: AB₂X₄. The A site in the spinel-type crystal structure is surrounded by anions of four X sites, and forms an isolated tetrahedron. The B site in the spinel-type crystal structure is surrounded by anions of six X sites, and forms an edge-sharing octahedron. It is found in an oxide in which A is a divalent metal element, B is a trivalent metal element, and X is oxygen. When the crystallite contained in the phosphor has a spinel-type crystal structure, the phosphor can be protected from external influences such as heat, ion bombardment, and vacuum ultraviolet irradiation, and at the same time, the light emission intensity of the phosphor can be enhanced.

In a preferred embodiment, the phosphor of the present invention is a phosphor having a core part formed of a crystal phase and a shell part formed on at least a portion of a surface of the core part. The shell part is generally an oxide containing at least one element selected from the group consisting of boron and silicon. In a preferred embodiment of the phosphor of the present invention, the shell part contains a metal element M.

The amount of the shell part is 30 wt% or less, preferably 0.01 to 20 wt%, and more preferably 0.05 to 10 wt%, based on the core part. When the amount of the shell part is more than 30 wt% based on the core part, a proportion of the core part to the total weight of the phosphor decreases, and the light emission intensity of the phosphor is likely to decrease.

Since the crystal structure of the surface of the crystal phase is likely to collapse, a defect portion having no light emission is formed. For example, when the metal element M constitutes a luminescent center ion, it is considered that the metal element M on the surface of the crystal phase forms a defect portion and reduces the light emission intensity. On the other hand, when the surface of the crystal phase is covered with the shell part, it is considered that the metal element M forming the defect portion on the surface of the crystal phase migrates to the shell part, such that the defect portion of the crystal phase decreases, and the light emission intensity increases.

The effect of improving the light emission intensity of the phosphor by forming the shell part on the surface of the crystal phase is due to a mechanism of improving the efficiency of the generated light to exit to the outside of the crystallite. This mechanism does not increase the amount of light generated by optimizing the element composition of the crystal phase. Therefore, it is considered that the effect of the present invention is achieved regardless of the element composition of the crystal phase.

The shell part present on the surface of the crystal phase contained in the phosphor of the present invention can be confirmed by detecting boron and/or silicon constituting the shell part by composition analysis such as X-ray photoelectron spectroscopy (XPS), energy dispersive X-ray spectroscopy (EDX), or inductively coupled plasma atomic emission spectroscopy (ICP-AES).

The core-shell structure of the phosphor of the present invention can be confirmed by performing EDX measurement of the cross section of the phosphor and obtaining an element mapping image. In the element mapping image, a region where the metal element M and boron or/and silicon coexist becomes a shell part. From the results of the EDX measurement, a ratio Y/X of a peak area value Y of boron or silicon to a peak area value X of the metal element M present in the shell part can be calculated. When both boron and silicon are contained in the shell part, either a ratio Y(B)/X or a ratio Y(Si)/X calculated based on a peak area value Y(B) of boron and a peak area value Y(Si) of silicon is used as the ratio Y/X.

A method for calculating the peak area value of each element from the result of the EDX measurement will be described. A peak at which intensity of a characteristic X-ray is the highest in the element of interest, that is, a peak detected with the highest intensity among the peaks derived from the element of interest is selected. In the peak, a point at which the peak rises is determined on each of the high energy side and the low energy side. The point at which the peak rises refers to a start point that monotonically increases toward the peak top. A point having low intensity is selected from the two start points, the intensity of the point is set to the background, that is, 0, and the peaks are integrated with reference to the background between the two points where the peak rises. The calculated integrated value is defined as a peak area value of the element. In particular, in manganese, two points of 5.66 keV and 6.15 keV are set as points at which peaks rise, and among these two points, a point with low intensity is set as 0, and peaks are integrated between the two points. This integrated value is defined as a peak area value of manganese. In boron, two points of 0.14 keV and 0.23 keV are set as points at which peaks rise, and among these two points, a point with low intensity is set as 0, and peaks are integrated between the two points. This integrated value is defined as a peak area value of boron. In silicon, two points of 1.60 keV and 1.95 keV are set as points at which peaks rise, and among these two points, a point with low intensity is set as 0, and peaks are integrated between the two points. This integrated value is defined as a peak area value of silicon.

Y/X in the phosphor of the present invention is, for example, 0 < Y/X ≤ 0.095, preferably 0 < Y/X ≤ 0.06, and more preferably 0 < Y/X ≤ 0.05. When Y/X is 0, the metal element M on the surface of the crystal phase forms a defect portion, and the light emission intensity is likely to decrease. In addition, when Y/X is larger than 0.095, the metal element M excessively migrates to the shell part, such that the metal element M in the core part decreases, and the light emission intensity is likely to decrease.

In the phosphor of the present invention, when the raw material of the shell part is liquefied, the metal element M forms an intermediate with the elements forming the shell part. Therefore, the metal element M is present in the shell part of the core-shell structure, and X does not become 0. That is, in the phosphor of the present invention, the metal element M is inevitably detected from the shell part. When both boron and silicon are not detected, Y/X = 0 is defined.

In the EDX measurement, a suitable measurement method can be selected according to a thickness of a sample to be measured. Examples of the measurement method include SEM-EDX, TEM-EDX, and STEM-EDX. Note that, in order to accurately detect boron by EDX measurement, windowless EDX is preferably used.

From the viewpoint of high spatial resolution and observation of many cross sections of the phosphor at a time, it is preferable to use a method in which the phosphor is processed by an ion milling apparatus to obtain a cross section of the phosphor, and then the cross section of the obtained phosphor is subjected to SEM-EDX measurement. Note that, in the calculation of Y/X using this method, it is preferable to analyze 20 or more shell parts and use an average value thereof from the viewpoint of improving accuracy. In addition, from the viewpoint of improving a shape of a spectrum, an acceleration voltage of the SEM is preferably set to 20 kV.

In the phosphor of the present invention, a central particle diameter of the particle diameter distribution, that is, D50 is usually 0.1 µm or more, and may be 1 to 500 µm, 1 to 200 µm, or 1 to 100 um. When D50 in the particle diameter distribution is less than 0.1 µm, the reflection on the outermost surface of the phosphor increases, such that that the light emission intensity is likely to decrease, and when D50 in the particle diameter distribution is more than 500 um, it is difficult to use the phosphor as a raw material of a member such as a film and an element.

The particle diameter distribution of the phosphor can be measured by, for example, a laser diffraction particle diameter analyzer. D50 in the particle diameter distribution is a particle diameter corresponding to a cumulative undersize distribution of 50% on a volume basis.

### <Raw Material of Phosphor>

As a raw material for producing the phosphor of the present invention, a compound or a simple substance containing at least a metal element or aluminum constituting a luminescent center ion is used as a raw material of a crystal phase. The compound containing aluminum includes an oxide, a hydroxide, a carbonate, an acetate, a nitrate, a fluoride, and a chloride of aluminum, and a silicate containing aluminum. Specific examples of the silicate containing aluminum include aluminum silicate, sodium aluminum silicate, magnesium aluminum silicate, potassium aluminum silicate, calcium aluminum silicate, β-sialon, and α-sialon. The compound containing aluminum is preferably aluminum oxide.

When the crystal phase is a magnesia-alumina spinel compound, a compound containing an element M, Al, Mg, oxygen, or nitrogen, or a simple substance is used as the raw material of the crystal phase. Examples of the raw material compound include an oxide, a hydroxide, a carbonate, an acetate, a nitrate, a fluoride, a chloride, or a nitride containing an element M, Al or Mg. Examples of the raw material compound containing an element M include manganese oxide, manganese carbonate, manganese acetate, manganese nitrate, manganese fluoride, manganese chloride, and manganese nitride; examples of the raw material compound containing Mg include magnesium oxide, magnesium hydroxide, magnesium carbonate, magnesium acetate, magnesium nitrate, magnesium fluoride, magnesium chloride, and magnesium nitride; and examples of the raw material compound containing Al include aluminum oxide, aluminum hydroxide, aluminum carbonate, aluminum acetate, aluminum nitrate, aluminum fluoride, aluminum chloride, and aluminum nitride.

When the crystal phase is a sialon compound, a raw material powder obtained by blending and mixing silicon nitride, aluminum nitride, aluminum oxide, and as necessary, an element M-containing compound is used according to the element composition of sialon. Examples of the raw material compound containing an element M include europium oxide, europium carbonate, europium acetate, europium nitrate, europium fluoride, europium chloride, and europium nitride.

In addition, a compound already having a sialon structure, such as β-sialon or α-sialon, may be used as the raw material powder.

The raw material compound containing aluminum is not particularly limited, and a raw material compound containing aluminum having a specific surface area of 0.01 to 15 m²/g, preferably 0.1 to 10 m²/g, more preferably 0.6 to 6 m²/g, and still more preferably 4 to 6 m²/g may be used from the viewpoint of increasing the size of the crystallite of the phosphor.

The specific surface area of the raw material compound containing aluminum can be measured by a BET method. The BET method is one of methods for measuring a surface area of a powder by a gas phase adsorption method. The total surface area per 1 g of a sample, that is, the specific surface area can be determined from an adsorption isotherm. As adsorption gas, nitrogen gas is usually used, and the adsorption amount is measured from a change in pressure or volume of the gas to be adsorbed. The adsorption amount is determined based on a BET equation, and the surface area can be obtained by multiplying an area occupied by one adsorption molecule on the surface.

In addition, D50 in a particle diameter distribution of the raw material compound containing aluminum is 0.2 µm to 90 µm, preferably 0.2 to 21 um, more preferably 0.2 to 10 µm, and still more preferably 0.2 to 1 µm, from the viewpoint of increasing the size of the crystallite of the phosphor.

When the phosphor of the present invention has a core-shell structure that includes a core part formed of a crystal phase and a shell part covering at least a portion of a surface of the core part, a compound containing at least one element selected from the group consisting of boron and silicon can be used as a raw material of the shell part. When the raw material of the crystal phase and the raw material of the shell part are used at the time of heating, the size of the crystallite of the phosphor increases. Examples of the raw material of the shell part include boron oxide, boron nitride, boric acid, and glass frit.

The glass frit is powder glass obtained by pulverizing glass. The main component is silicon dioxide, and may include aluminum oxide, bismuth oxide, calcium oxide, boron oxide, barium oxide, strontium oxide, calcium oxide, sodium oxide, zinc oxide, lithium oxide, potassium oxide, zirconium oxide, and the like.

When the phosphor of the present invention is produced, lithium fluoride may be added as a raw material other than the raw material compound described above from the viewpoint of enhancing crystallinity.

### <Method for Producing Phosphor>

The phosphor of the present invention can be produced, for example, by the following method. That is, first, the raw materials of the crystal phase are weighed so that the element M, Mg, Si, Al, O, and N have a predetermined molar ratio defined in Formula (1), (2), (3), or (4), and these raw materials are mixed. At this time, the raw material of the shell part at a predetermined ratio with respect to the total amount may be weighed and mixed together with the raw material of the crystal phase. The mixing can be performed using a mixing apparatus such as a ball mill, a sand mill, or a Picomill.

Next, the prepared raw material mixture is heated. The heating is performed at a temperature at which the raw material of the shell part is liquefied but the host crystal of the phosphor to be obtained can be maintained. For example, when a heating temperature is 1,700°C or lower, a desired crystal structure can be obtained without collapsing the host crystal of the phosphor.

The heating temperature is adjusted to a temperature suitable for forming a predetermined host crystal in consideration of the element composition of the crystal phase to be produced. In the production method of the present invention, the host crystal is a crystal having a crystal structure of a core part of the obtained phosphor.

When the crystal phase is a magnesia-alumina spinel compound, the heating temperature of the raw material mixture is, for example, 1,250 to 1,700°C, preferably 1,300°C to 1,650°C, more preferably 1,350°C to 1,600°C, and still more preferably 1,400°C to 1,600°C.

When the crystal phase is a sialon compound, the heating temperature of the raw material mixture is, for example, 14,00°C to 2,400°C, preferably 1,600°C to 2,300°C, more preferably 1,800°C to 2,200°C, and still more preferably 1,900°C to 2,100°C.

A heating atmosphere is preferably a mixed atmosphere of hydrogen and nitrogen. In the mixed atmosphere used for the heating atmosphere, a ratio of hydrogen to nitrogen is preferably 1:99 to 100:0, and the ratio of hydrogen to nitrogen is more preferably 5:95 to 10:90.

A heating time is acceptable as long as it is an industrially realistic time, and is, for example, 1 to 10 hours, and preferably 2 to 8 hours when the heating temperature is in the above range. By setting the heating time within this range, a desired crystal structure can be obtained without collapsing the host crystal of the phosphor. The phosphor of the present invention may be produced using the solid phase reaction method, or may be synthesized using another production method, for example, a solution method, a melt synthesis method, or the like.

### <Composition>

The phosphor of the present invention can be used as a composition by being dispersed in a monomer, a resin, or a mixture of a monomer and a resin. A resin component of the composition may be a polymer obtained by polymerizing a monomer.

Examples of the monomer used in the composition include methyl (meth)acrylate, ethyl (meth)acrylate, methoxyethyl (meth)acrylate, ethoxyethyl (meth)acrylate, n-propyl (meth)acrylate, isopropyl (meth)acrylate, n-butyl (meth)acrylate, isobutyl (meth)acrylate, tert-butyl (meth)acrylate, 2-ethylhexyl (meth)acrylate, cyclohexyl (meth)acrylate, heptyl (meth)acrylate, octyl (meth)acrylate, nonyl (meth)acrylate, dodecyl (meth)acrylate, lauryl (meth)acrylate, stearyl (meth)acrylate, cyclopentyl (meth)acrylate, cyclohexyl (meth)acrylate, 2-methylcyclohexyl (meth)acrylate, isobornyl (meth)acrylate, adamantyl (meth)acrylate, allyl (meth)acrylate, propargyl (meth)acrylate, phenyl (meth)acrylate, naphthyl (meth)acrylate, benzyl (meth)acrylate, nonylphenylcarbitol (meth)acrylate, 2-hydroxy-3-phenoxypropyl (meth)acrylate, 2-ethylhexylcarbitol (meth)acrylate, 2-hydroxyethyl (meth)acrylate, 2-hydroxypropyl (meth)acrylate, ethylene glycol di(meth)acrylate, triethylene glycol di(meth)acrylate, neopentyl glycol di(meth)acrylate, 1,6-hexanediol di(meth)acrylate, 1,7-heptanediol di(meth)acrylate, 1,8-octanediol di(meth)acrylate, 1,9-nonanediol di(meth)acrylate, 1,10-decanediol di(meth)acrylate, bis[(meth)acryloyloxyethyl]ether of bisphenol A, 3-ethylpentanediol di(meth)acrylate, trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, ethylene glycol-modified trimethylolpropane tri(meth)acrylate, propylene glycol modified trimethylolpropane tri(meth)acrylate, ethylene glycol-modified pentaerythritol tetra(meth)acrylate, propylene glycol-modified pentaerythritol tetra(meth)acrylate, ethylene glycol-modified dipentaerythritol hexa(meth)acrylate, propylene glycol-modified dipentaerythritol hexa(meth)acrylate, caprolactone-modified pentaerythritol tetra(meth)acrylate, caprolactone-modified dipentaerythritol hexa(meth)acrylate, dipentaerythritol penta(meth)acrylate succinic acid monoester, tris(2-(meth)acryloyloxyethyl)isocyanurate, and dicyclo pentanyl (meth)acrylate.

Preferred examples of the (meth)acrylate include isobornyl (meth)acrylate, stearyl (meth)acrylate, methyl (meth)acrylate, cyclohexyl (meth)acrylate, and dicyclopentanyl (meth)acrylate from the viewpoint of improving heat resistance, water resistance, light resistance, and light emission intensity.

These monomers may be used alone or as a mixture of a plurality of kinds of thereof.

The resin used in the composition is not particularly limited, and examples thereof include a (meth)acrylic resin, a styrene resin, an epoxy resin, a urethane resin, and a silicone resin.

The silicone resin is not particularly limited, and examples thereof include addition polymerizable silicone polymerized by an addition polymerization reaction of a silyl group and a vinyl group and condensation polymerizable silicone polymerized by condensation polymerization of alkoxysilane. From the viewpoint of improving heat resistance, water resistance, light resistance, and light emission intensity, addition polymerizable silicone is preferable.

As the silicone resin, a silicone resin in which an organic group is bonded to a Si element in silicone is preferable, and examples thereof include functional groups such as an alkyl group such as a methyl group, an ethyl group, or a propyl group, a phenyl group, and an epoxy group. From the viewpoint of improving heat resistance, water resistance, light resistance, and light emission intensity, a phenyl group is preferable.

Examples of the silicone resin include KE-108 (manufactured by Shin-Etsu Chemical Co., Ltd.), KE-1031 (manufactured by Shin-Etsu Chemical Co., Ltd.), KE-109E (manufactured by Shin-Etsu Chemical Co., Ltd.), KE-255 (manufactured by Shin-Etsu Chemical Co., Ltd.), KR-112 (manufactured by Shin-Etsu Chemical Co., Ltd.), KR-251 (manufactured by Shin-Etsu Chemical Co., Ltd.), and KR-300 (manufactured by Shin-Etsu Chemical Co., Ltd.).

These silicones may be used alone or as a mixture of a plurality of kinds of thereof.

A proportion of the monomer component and/or the resin component contained in the composition is not particularly limited, and is 10 wt% or more and 99 wt% or less, preferably 20 wt% or more and 80 wt% or less, and more preferably 30 wt% or more and 70 wt% or less.

The composition may contain a curing agent from the viewpoint of curing the monomer component and/or the resin component and improving heat resistance, water resistance, light resistance, and light emission intensity. Examples of the curing agent include curing agents having a plurality of functional groups. Examples of the curing agent having a plurality of functional groups include trimethylolpropane triacrylate, pentaerythritol tetraacrylate, ditrimethylolpropane tetraacrylate, dipentaerythritol hexaacrylate, and a mercapto compound containing a thiol group.

A proportion of the curing agent contained in the composition is not particularly limited, and is 0.1 wt% or more and 20 wt% or less, preferably 1 wt% or more and 10 wt% or less, and more preferably 2 wt% or more and 7 wt% or less.

The composition may contain an initiator from the viewpoint of polymerizing the monomer component and/or the resin component and improving heat resistance, water resistance, light resistance, and light emission intensity. The initiator may be a photopolymerization initiator or a thermal polymerization initiator.

The thermal polymerization initiator used in the present invention is not particularly limited, and examples thereof include an azo-based initiator, peroxide, persulfuric acid, and a redox initiator.

The azo-based initiator is not particularly limited, and examples thereof include 2,2'-azobis(4-methoxy-2,4-dimethylvaleronitrile), 2,2'-azobis(2-amidinopropane) dihydrochloride, 2,2'-azobis(2,4-dimethylvaleronitrile), 2,2'-azobis(isobutyronitrile), 2,2'-azobis-2-methylbutyronitrile, 1,1-azobis(1-cyclohexanecarbonitrile), 2,2'-azobis(2-cyclopropylpropionitrile), and 2,2'-azobis(methyl isobutyrate).

The peroxide initiator is not particularly limited, and examples thereof include benzoyl peroxide, acetyl peroxide, lauroyl peroxide, decanoyl peroxide, dicumyl peroxide, dicetyl peroxydicarbonate, t-butyl peroxyisopropyl monocarbonate, di(4-t-butylcyclohexyl) peroxydicarbonate, di(2-ethylhexyl) peroxydicarbonate, t-butyl peroxypivalate, and t-butyl peroxy-2-ethylhexanoate.

The persulfate initiator is not particularly limited, and examples thereof include potassium persulfate, sodium persulfate, and ammonium persulfate.

The redox (oxidation-reduction) initiator is not particularly limited, and examples thereof include a combination of the persulfate initiator with a reducing agent such as sodium metabisulfite and sodium bisulfite; a system based on an organic peroxide and a tertiary amine, for example, a system based on benzoyl peroxide and dimethylaniline; and a system based on an organic hydroperoxide and a transition metal, for example, a system based on cumene hydroperoxide and cobalt naphthenate.

The other initiators are not particularly limited, and examples thereof include pinacol such as tetraphenyl 1,1,2,2-ethanediol.

As the thermal polymerization initiator, an azo-based initiator and a peroxide-based initiator are preferable, and more preferably, examples thereof include 2,2'-azobis(methyl isobutyrate), t-butyl peroxypivalate, di(4-t-butyl cyclohexyl) peroxydicarbonate, t-butyl peroxyisopropyl monocarbonate, and benzoyl peroxide.

The photopolymerizaiton initiator is not particularly limited, and examples thereof include an oxime-based compound such as an O-acyloxime compound, an alkylphenone compound, and an acyl phosphine oxide compound.

Examples of the O-acyloxime compound include N-benzoyloxy-1-(4-phenylsulfanylphenyl)butan-1-one-2-imine, N-benzoyloxy-1-(4-phenylsulfanylphenyl)octan-1-one-2-imine, N-benzoyloxy-1-(4-phenylsulfanylphenyl)-3-cyclopentylpropan-1-one-2-imine, N-acetoxy-1-[9-ethyl-6-(2-methylbenzoyl)-9H-carbazol-3-yl]ethan-1-imine, N-acetoxy-1-[9-ethyl-6-{2-methyl-4-(3,3-dimethyl-2,4-dioxacyclopentanylmethyloxy)benzoyl}-9H-carbazol-3-yl]ethane-1-imine, N-acetoxy-1-[9-ethyl-6-(2-methylbenzoyl)-9H-carbazol-3-yl]-3-cyclopentylpropane-1-imine, N-benzoyloxy-1-[9-ethyl-6-(2-methylbenzoyl)-9H-carbazol-3-yl]-3-cyclopentylpropan-1-one-2-imine, N-acetyloxy-1-[4-(2-hydroxyethyloxy)phenylsulfanylphenyl]propan-1-one-2-imine, and N-acetyloxy-1-[4-(1-methyl-2-methoxyethoxy)-2-methylphenyl]-1-(9-ethyl-6-nitro-9H-carbazol-3-yl)methane-1-imine.

Commercially available products such as Irgacure (trade name) OXE01, Irgacure OXE02, and Irgacure OXE03 (manufactured by BASF SE), and N-1919, NCI-930, and NCI-831 (manufactured by ADEKA Corporation) may be used.

Examples of the alkylphenone compound include 2-methyl-2-morpholino-1-(4-methylsulfanylphenyl)propan-1-one, 2-dimethylamino-1-(4-morpholinophenyl)-2-benzylbutan-1-one, 2-(dimethylamino)-2-[(4-methylphenyl)methyl]-1-[4-(4-morpholinyl)phenyl]butan-1-one, 2-hydroxy-2-methyl-1-phenylpropan-1-one, 2-hydroxy-2-methyl-1-[4-(2-hydroxyethoxy)phenyl]propan-1-one, 1-hydroxycyclohexylphenyl ketone, an oligomer of 2-hydroxy-2-methyl-1-(4-isopropenylphenyl)propan-1-one, α,α-diethoxyacetophenone, and benzyl dimethyl ketal.

Commercially available products such as Omnirad (trade name) 369, Omnirad 907, and Omnirad 379 (manufactured by IGM Resins B.V.) may be used.

Examples of the acyl phosphine oxide compound include phenylbis(2,4,6-trimethylbenzoyl)phosphine oxide (for example, trade name "Omnirad 819", manufactured by IGM Resins B.V.) and 2,4,6-trimethylbenzoyldiphenylphosphine oxide. Further examples of the photopolymerization initiator include a benzoin compound such as benzoin, benzoin methyl ether, benzoin ethyl ether, benzoin isopropyl ether, or benzoin isobutyl ether; a benzophenone compound such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, 2,4,6-trimethylbenzophenone, or 4,4'-di(N,N'-dimethylamino)-benzophenone; a xanthone compound such as 2-isopropylthioxanthone or 2,4-diethylthioxanthone; an anthracene compound such as 9,10-dimethoxyanthracene, 2-ethyl-9,10-dimethoxyanthracene, 9,10-diethoxyanthracene, or 2-ethyl-9,10-diethoxyanthracene; a quinone compound such as 9,10-phenanthrenequinone, 2-ethylanthraquinone, or camphorquinone; and benzyl, methyl phenylglyoxylate, and titanocene compounds.

The composition may contain an antioxidant from the viewpoint of suppressing oxidation of the composition and improving heat resistance, water resistance, light resistance, and light emission intensity. Examples of the antioxidant include an amine-based antioxidant, a sulfur-based antioxidant, a phenolic antioxidant, a phosphorus-based antioxidant, a phosphorus-phenol-based antioxidant, and a metal compound-based antioxidant, and the antioxidant preferably includes at least one selected from the group consisting of an amine-based antioxidant, a sulfur-based antioxidant, a phenolic antioxidant, and a phosphorus-based antioxidant, and more preferably includes at least one selected from the group consisting of a sulfur-based antioxidant, a phenolic antioxidant, and a phosphorus-based antioxidant.

The amine-based antioxidant is an antioxidant having an amino group in the molecule. Examples of the amine-based antioxidant include a naphthylamine-based antioxidant such as 1-naphthylamine, phenyl-1-naphthylamine, p-octylphenyl-1-naphthylamine, p-nonylphenyl-1-naphthylamine, p-dodecylphenyl-1-naphthylamine, or phenyl-2-naphthylamine; a phenylenediamine-based antioxidant such as N,N'-diisopropyl-p-phenylenediamine, N,N'-diisobutyl-p-phenylenediamine, N,N'-diphenyl-p-phenylenediamine, N,N'-di-β-naphthyl-p-phenylenediamine, N-phenyl-N'-isopropyl-p-phenylenediamine, N-cyclohexyl-N'-phenyl-p-phenylenediamine, N-1,3-dimethylbutyl-N'-phenyl-p-phenylenediamine, dioctyl-p-phenylenediamine, phenylhexyl-p-phenylenediamine, or phenyloctyl-p-phenylenediamine; a diphenylamine-based antioxidant such as dipyridylamine, diphenylamine, p,p'-di-n-butyldiphenylamine, p,p'-di-tert-butyldiphenylamine, p,p'-di-tert-pentyldiphenylamine, p,p'-dioctyldiphenylamine, p,p'-dinonyldiphenylamine, p,p'-didecyldiphenylamine, p,p'-didodecyldiphenylamine, p,p'-distyryldiphenylamine, p,p'-dimethoxydiphenylamine, 4,4'-bis(4-α,α-dimethylbenzoyl)diphenylamine, p-isopropoxydiphenylamine, or dipyridylamine; a phenothiazine antioxidant such as phenothiazine, N-methylphenothiazine, N-ethylphenothiazine, 3,7-dioctylphenothiazine, phenothiazine carboxylic acid ester, or phenoselenazine; bis(2,2,6,6-tetramethyl-4-piperidinyl) sebacate (trade name "Tinuvin 770", manufactured by BASF SE); and [(4-methoxyphenyl)-methylene]-bis(1,2,2,6,6-pentamethyl-4-piperidinyl) malonate (trade name "Hostavin PR31", manufactured by Clariant AG).

The sulfur-based antioxidant is an antioxidant having a sulfur atom in the molecule. Examples of the sulfur-based antioxidant include a dialkyl thiodipropionate compound such as dilauryl thiodipropionate, dimyristyl, or distearyl thiodipropionate ("Sumilizer TPM" (trade name, manufactured by Sumitomo Chemical Co., Ltd.), and the like), a β-alkylmercaptopropionic acid ester compound of polyols such as tetrakis[methylene(3-dodecylthio)propionate]methane or tetrakis[methylene(3-laurylthio)propionate]methane, and 2-mercaptobenzimidazole.

The phenolic antioxidant is an antioxidant having a phenolic hydroxy group in the molecule. In the present specification, a phosphorus-phenol-based antioxidant that has both a phenolic hydroxy group and a phosphoric acid ester structure or phosphorous acid ester structure is classified as a phenolic antioxidant. Examples of the phenolic antioxidant include 1,1,3-tris(2-methyl-4-hydroxy-5-tert-butylphenyl)butane, 4,4'-butylidene-bis(3-methyl-6-tert-butylphenol), 1,3,5-trimethyl-2,4,6-tris(3,5-di-tert-butyl-4-hydroxybenzyl)benzene, 2-tert-butyl-6-(3-tert-butyl-2-hydroxy-5-methylbenzyl)-4-methylphenyl acrylate, (tetrakis[methylene-3-(3,5-di-tert-butyl-4-hydroxyphenyl)propionate]methane, pentaerythritol tetrakis[3-(3,5-di-tert-butyl-4-hydroxyphenyl)propionate], octadecyl-3-(3,5-di-tert-butyl-4-hydroxyphenyl)propionate ("Irganox 1076" (trade name, manufactured by BASF SE)), 3,3',3'',5,5',5''-hexa-tert-butyl-a,a',a''-(mesitylene-2,4,6-triyl)tri-p-cresol, 1,3,5-tris(3,5-di-tert-butyl-4-hydroxybenzyl)-1,3,5-triazine-2,4,6(1H,3H,5H)-trione, 1,3,5-tris((4-tert-butyl-3-hydroxy-2,6-xylyl)methyl)-1,3,5-triazine-2,4,6(1H,3H,5H)-trione, thiodiethylene bis[3-(3,5-di-tert-butyl-4-hydroxyphenyl)propionate], benzenepropanoic acid, 3,5-bis(1,1-dimethylethyl)-4-hydroxy C7-C9 side chain alkyl ester, 4,6-bis(octylthiomethyl)-o-cresol, 2,4-bis(n-octylthio)-6-(4-hydroxy-3',5'-di-tert-butylanilino)-1,3,5-triazine, 3,9-bis(2-(3-(3-tert-butyl-4-hydroxy-5-methylphenyl)propionyloxy)-1,1-dimethylethyl)-2,4,8,10-tetraoxaspiro(5,5)undecane (trade name "ADEKASTAB AO-80" manufactured by ADEKA Corporation), triethylene glycol-bis[3-(3-tert-butyl-5-methyl-4-hydroxyphenyl)propionate], 4,4'-thiobis(6-tert-butyl-3-methylphenol), tris-(3,5-di-tert-butyl-4-hydroxybenzyl)-isocyanurate, 1,3,5-tris(4-tert-butyl-3-hydroxy-2,6-dimethylbenzyl)-isocyanurate, 1,6-hexanediol-bis[3-(3,5-di-tert-butyl-4-hydroxyphenyl)propionate], N,N'-hexamethylenebis(3,5-di-tert-butyl-4-hydroxy-hydrocinnamamide), 1,3,5-trimethyl-2,4,6-tris(3,5-di-tert-butyl-4-hydroxybenzyl)benzene, 1,6-hexanediol-bis-[3-(3,5-di-tert-butyl-4-hydroxyphenyl)propionate], 2,2'-methylenebis(4-methyl-6-tert-butylphenol), 1,3,5-tris(4-hydroxybenzyl)benzene, 6,6'-di-tert-butyl-4,4'-butylidenedi-m-cresol (trade name "ADEKASTAB AO-40", manufactured by ADEKA Corporation), "Irganox 3125" (trade name, manufactured by BASF SE), "Sumilizer BHT" (trade name, manufactured by Sumitomo Chemical Co., Ltd.), "Sumilizer GA-80" (trade name, manufactured by Sumitomo Chemical Co., Ltd.), "Sumilizer GS" (trade name, manufactured by Sumitomo Chemical Co., Ltd.), "Cyanox 1790" (trade name, manufactured by Cytec Industries, Inc.), and vitamin E (manufactured by Eisai Co., Ltd.).

Examples of the phosphorus-phenol-based antioxidant include 2,10-dimethyl-4,8-di-tert-butyl-6-[3-(3,5-di-tert-butyl-4-hydroxyphenyl)propoxy]-12H-dibenzo[d,g][1,3,2]dioxaphosphocin, 2,4,8,10-tetra-tert-butyl-6-[3-(3,5-di-tert-butyl-4-hydroxyphenyl)propoxy]dibenzo[d,f][1,3,2]dioxaphosphepin, and 2,4,8,10-tetra-tert-butyl-6-[3-(3,5-di-tert-butyl-4-hydroxyphenyl)propionyloxy]-dibenzo[d,f][1,3,2]dioxaphosphepin (trade name "Sumilizer GP", manufactured by Sumitomo Chemical Co., Ltd.).

The phosphorus-based antioxidant is an antioxidant having a phosphoric acid ester structure or a phosphorous acid ester structure. Examples of the phosphorus-based antioxidant include diphenyl isooctyl phosphite, 2,2'-methylenebis(4,6-di-tert-butylphenyl)octyl phosphite, diphenyl isodecyl phosphite, diphenyl isodecyl phosphite, triphenyl phosphate, tributyl phosphate, diisodecyl pentaerythritol diphosphite, distearyl pentaerythritol diphosphite, cyclic neopentanetetrayl bis(2,4-di-tert-butylphenyl)phosphite, cyclic neopentanetetrayl bis(2,6-di-tert-butylphenyl) phosphite, cyclic neopentanetetrayl bis(2,6-di-tert-butyl-4-methylphenyl)phosphite, 6-[3-(3-tert-butyl-4-hydroxy-5-methylphenyl)propoxy]-2,4,8,10-tetra-tert-butylbenzo[d,f][1,3,2]dioxaphosphepin, tris(nonylphenyl) phosphite (trade name "ADEKASTAB 1178", manufactured by ADEKA Corporation), tris(mono- & dinonylphenyl mixed) phosphite, diphenyl mono(tridecyl) phosphite, 2,2'-ethylidenebis(4,6-di-tertbutylphenol)fluorophosphite, phenyl diisodecyl phosphite, tris(2-ethylhexyl) phosphite, tris(isodecyl) phosphite, tris(tridecyl) phosphite, tris(2,4-di-tert-butylphenyl) phosphite, tetrakis(2,4-di-tert-butylphenyl)-4,4'-biphenylene-di-phosphonite, 4,4'-isopropylidene diphenyl tetraalkyl(C12-C15) diphosphite, 4,4'-butylidenebis(3-methyl-6-tert-butylphenyl)-ditridecyl phosphite, bis(nonylphenyl)pentaerythritol diphosphite, bis(2,4-di-tert-butylphenyl)pentaerythritol diphosphite, cyclic neopentanetetrayl bis(2,6-di-tert-butyl-4-methylphenyl-phosphite), 1,1,3-tris(2-methyl-4-ditridecyl phosphite-5-tert-butylphenyl)butane, tetrakis(2,4-di-tert-butyl-5-methylphenyl)-4,4'-biphenylene diphosphonite, tri-2-ethylhexyl phosphite, triisodecyl phosphite, tristearyl phosphite, phenyl diisodecyl phosphite, trilauryl trithiophosphite, distearylpentaerythritol diphosphite, tris(nonylphenyl) phosphite, tris[2-[[2,4,8,10-tetra-tert-butyldibenzo[d,f][1,3,2]dioxaphosphin-6-yl]oxy]ethyl]amine, bis(2,4-bis(1,1-dimethylethyl)-6-methylphenyl)ethyl ester phosphorous acid, 3,9-bis(2,6-di-tert-butyl-4-methylphenoxy)-2,4,8,10-tetraoxa-3,9-diphosphaspiro[5.5]undecane, bis(2,4-di-tert-butylphenyl)pentaerythritol diphosphite, 2,2'-methylenebis(4,6-di-tert-butyl-1-phenyloxy) (2-ethylhexyloxy) phosphorus, triphenyl phosphite, 4,4'-butylidene-bis(3-methyl-6-tert-butylphenylditridecyl)phosphite, octadecyl phosphite, 9,10-dihydro-9-oxa-10-phosphaphenanthrene 10-oxide, 10-(3,5-di-tert-butyl-4-hydroxybenzyl)-9,10-dihydro-9-oxa-10-phosphaphenanthrene 10-oxide, 10-decyloxy-9,10-dihydro-9-oxa-10-phosphaphenanthrene 10-oxide, 2,2-methylenebis(4,6-di-tert-butylphenyl)octyl phosphite, tetrakis(2,4-di-tert-butylphenyl) [1,1-biphenyl]-4,4'-diyl bisphosphonite, bis[2,4-bis(1,1-dimethylethyl)-6-methylphenyl]ethyl ester, phosphonic acid, "ADEKASTAB 329K" (trade name, manufactured by ADEKA Corporation), "ADEKASTAB PEP36" (trade name, manufactured by ADEKA Corporation), "ADEKASTAB PEP-8" (trade name, manufactured by ADEKA Corporation), "Sandstab P-EPQ" (trade name, manufactured by Clariant AG), "Weston 618" (trade name, manufactured by General Electric Company), "Weston 619G" (trade name, manufactured by General Electric Company), and "ULTRANOX 626" (trade name, manufactured by General Electric Company).

A proportion of the antioxidant contained in the composition is not particularly limited, and is 0.1 wt% or more and 20 wt% or less, preferably 1 wt% or more and 10 wt% or less, and more preferably 2 wt% or more and 7 wt% or less.

The composition may contain a light scattering material from the viewpoint of scattering light passing through the composition, improving the amount of light absorbed by the composition, and improving the light emission intensity. The light scattering material is not particularly limited, and examples thereof include polymer fine particles and inorganic fine particles. Examples of a polymer used for the polymer fine particles include an acrylic resin, an epoxy resin, a silicone resin, and a urethane resin.

Examples of the inorganic fine particles used for the light scattering material include fine particles containing known inorganic compounds such as an oxide, a hydroxide, a sulfide, a nitride, a carbide, a chloride, a bromide, an iodide, and a fluoride.

In the light scattering material, examples of the oxide contained in the inorganic fine particles include known oxides such as silicon oxide, aluminum oxide, zinc oxide, niobium oxide, zirconium oxide, titanium oxide, magnesium oxide, cerium oxide, yttrium oxide, strontium oxide, barium oxide, calcium oxide, tungsten oxide, indium oxide, gallium oxide, titanium oxide, and a mixture thereof, aluminum oxide, zinc oxide, and niobium oxide are preferable, aluminum oxide and niobium oxide are more preferable, and niobium oxide is most preferable.

In the light scattering material, examples of the aluminum oxide contained in the inorganic fine particles include known aluminum oxides such as α-alumina, γ-alumina, θ-alumina, δ-alumina, η-alumina, κ-alumina, and χ-alumina, α-alumina and γ-alumina are preferable, and α-alumina is more preferable.

In the light scattering material, the aluminum oxide may be a commercially available product, and raw materials such as aluminum nitrate, aluminum chloride, and aluminum alkoxide may be fired to obtain alumina. Examples of commercially available aluminum oxide include AKP-20 (manufactured by Sumitomo Chemical Co., Ltd.), AKP-30 (manufactured by Sumitomo Chemical Co., Ltd.), AKP-50 (manufactured by Sumitomo Chemical Co., Ltd.), AKP-53 (manufactured by Sumitomo Chemical Co., Ltd.), AKP-3000 (manufactured by Sumitomo Chemical Co., Ltd.), AA-02 (manufactured by Sumitomo Chemical Co., Ltd.), AA-03 (manufactured by Sumitomo Chemical Co., Ltd.), AA-04 (manufactured by Sumitomo Chemical Co., Ltd.), AA-05 (manufactured by Sumitomo Chemical Co., Ltd.), AA-07 (manufactured by Sumitomo Chemical Co., Ltd.), AA-1.5 (manufactured by Sumitomo Chemical Co., Ltd.), AA-3 (manufactured by Sumitomo Chemical Co., Ltd.), and AA-18 (manufactured by Sumitomo Chemical Co., Ltd.), AA-02 (manufactured by Sumitomo Chemical Co., Ltd.), AA-3 (manufactured by Sumitomo Chemical Co., Ltd.), AA-18 (manufactured by Sumitomo Chemical Co., Ltd.), AKP-20 (manufactured by Sumitomo Chemical Co., Ltd.), AKP-3000 (manufactured by Sumitomo Chemical Co., Ltd.), AKP-53 (manufactured by Sumitomo Chemical Co., Ltd.), AKP-30 (manufactured by Sumitomo Chemical Co., Ltd.), and AKP-50 (manufactured by Sumitomo Chemical Co., Ltd.) are preferable, and AA-02 (manufactured by Sumitomo Chemical Co., Ltd.), AA-3 (manufactured by Sumitomo Chemical Co., Ltd.), AKP-53 (manufactured by Sumitomo Chemical Co., Ltd.), AKP-3000 (manufactured by Sumitomo Chemical Co., Ltd.), AKP-30 (manufactured by Sumitomo Chemical Co., Ltd.), and AKP-50 (manufactured by Sumitomo Chemical Co., Ltd.) are more preferable, from the viewpoint of absorbance.

Examples of the hydroxide contained in the inorganic fine particles in the light scattering material include known oxides such as aluminum hydroxide, zinc hydroxide, magnesium hydroxide, cerium hydroxide, yttrium hydroxide, strontium hydroxide, barium hydroxide, calcium hydroxide, indium hydroxide, gallium hydroxide, and a mixture thereof, and aluminum hydroxide and zinc hydroxide are preferable.

Examples of the sulfide contained in the inorganic fine particles in the light scattering material include known sulfides such as silicon sulfide, aluminum sulfide, zinc sulfide, niobium sulfide, zirconium sulfide, titanium sulfide, magnesium sulfide, cerium sulfide, yttrium sulfide, strontium sulfide, barium sulfide, calcium sulfide, tungsten sulfide, indium sulfide, gallium sulfide, and a mixture thereof, aluminum sulfide, zinc sulfide, and niobium sulfide are preferable, zinc sulfide and niobium sulfide are preferable, and niobium sulfide is most preferable.

Examples of the nitride contained in the inorganic fine particles in the light scattering material include known nitrides such as silicon nitride, aluminum nitride, zinc nitride, niobium nitride, zirconium nitride, titanium nitride, magnesium nitride, cerium nitride, yttrium nitride, strontium nitride, barium nitride, calcium nitride, tungsten nitride, indium nitride, gallium nitride, and a mixture thereof, aluminum nitride, zinc nitride, and niobium nitride are preferable, aluminum nitride and niobium nitride are more preferable, and niobium nitride is most preferable.

Examples of the carbide contained in the inorganic fine particles in the light scattering material include known carbides such as silicon carbide, aluminum carbide, zinc carbide, niobium carbide, zirconium carbide, titanium carbide, magnesium carbide, cerium carbide, yttrium carbide, strontium carbide, barium carbide, calcium carbide, tungsten carbide, indium carbide, gallium carbide, and a mixture thereof, aluminum carbide, zinc carbide, and niobium carbide are preferable, aluminum carbide and niobium carbide are more preferable, and niobium carbide is most preferable.

Examples of the chloride contained in the inorganic fine particles in the light scattering material include known chlorides such as silicon chloride, aluminum chloride, zinc chloride, niobium chloride, zirconium chloride, titanium chloride, magnesium chloride, cerium chloride, yttrium chloride, strontium chloride, barium chloride, calcium chloride, tungsten chloride, indium chloride, gallium chloride, and a mixture thereof, aluminum chloride, zinc chloride, and niobium chloride are preferable, aluminum chloride and niobium chloride are more preferable, and niobium chloride is most preferable.

Examples of the bromide contained in the inorganic fine particles in the light scattering material include known bromides such as silicon bromide, aluminum bromide, zinc bromide, niobium bromide, zirconium bromide, titanium bromide, magnesium bromide, cerium bromide, yttrium bromide, strontium bromide, barium bromide, calcium bromide, tungsten bromide, indium bromide, gallium bromide, and a mixture thereof, aluminum bromide, zinc bromide, and niobium bromide are preferable, aluminum bromide and niobium bromide are more preferable, and niobium bromide is most preferable.

Examples of the iodide contained in the inorganic fine particles in the light scattering material include known iodides such as silicon iodide, aluminum iodide, zinc iodide, niobium iodide, zirconium iodide, titanium iodide, magnesium iodide, gallium iodide, cerium iodide, yttrium iodide, strontium iodide, barium iodide, calcium iodide, tungsten iodide, indium iodide, and a mixture thereof, aluminum iodide, zinc iodide, and niobium iodide are preferable, aluminum iodide and niobium iodide are more preferable, and niobium iodide is most preferable.

Examples of the fluoride contained in the inorganic fine particles in the light scattering material include known fluorides such as silicon fluoride, aluminum fluoride, zinc fluoride, niobium fluoride, zirconium fluoride, titanium fluoride, magnesium fluoride, cerium fluoride, yttrium fluoride, strontium fluoride, barium fluoride, calcium fluoride, tungsten fluoride, indium fluoride, gallium fluoride, and a mixture thereof, aluminum fluoride, zinc fluoride, and niobium fluoride are preferable, aluminum fluoride and niobium fluoride are more preferable, and niobium fluoride is most preferable.

As the light scattering material, aluminum oxide, silicon oxide, zinc oxide, titanium oxide, niobium oxide, and zirconium oxide are preferable, and aluminum oxide is preferable, from the viewpoint of scattering light passing through the composition, improving the light absorption amount of the composition, and improving the light emission intensity.

A particle diameter of the light scattering material contained in the composition is not particularly limited, and is 0.1 um or more and 50 µm or less, preferably 0.3 µm or more and 10 µm or less, and more preferably 0.5 um or more and 5 µm or less.

A proportion of the light scattering material contained in the composition is not particularly limited, and is 0.1 wt% or more and 20 wt% or less, preferably 1 wt% or more and 10 wt% or less, and more preferably 2 wt% or more and 7 wt% or less.

The composition may contain an additional light emitting material other than the phosphor of the present invention from the viewpoint of adjusting the color of light emitted by the composition and achieving a high color gamut. Examples of the additional light emitting material other than the phosphor of the present invention contained in the composition include phosphors and quantum dots other than the phosphor of the present invention.

The quantum dot contained in the composition is not particularly limited as long as it is a quantum dot particle capable of emitting fluorescence in a visible light wavelength region, and can be selected from the group consisting of, for example, a II-VI semiconductor compound; a III-V semiconductor compound; a IV-VI semiconductor compound; a IV element or a compound containing the same; and a combination thereof. These quantum dots can be used alone or as a mixture of two or more thereof.

The II-VI semiconductor compound can be selected from the group consisting of a binary compound selected from the group consisting of CdS, CdSe, CdTe, ZnS, ZnSe, ZnTe, ZnO, HgS, HgSe, HgTe, and a mixture thereof; a ternary compound selected from the group consisting of CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, and a mixture thereof; and a quaternary compound selected from the group consisting of CdZnSeS, CdZnSeTe, CdZnSTe, CdHgSeS, CdHgSeTe, CdHgSTe, HgZnSeS, HgZnSeTe, HgZnSTe, and a mixture thereof.

The III-V semiconductor compound can be selected from the group consisting of a binary compound selected from the group consisting of GaN, GaP, GaAs, GaSb, AlN, AlP, AlAs, AlSb, InN, InP, InAs, InSb, and a mixture thereof; a ternary compound selected from the group consisting of GaNP, GaNAs, GaNSb, GaPAs, GaPSb, AlNP, AlNAs, AlNSb, AlPAs, AlPSb, InNP, InNAs, InNSb, InPAs, InPSb, GaAlNP, and a mixture thereof; and a quaternary compound selected from the group consisting of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, and a mixture thereof.

The IV-VI semiconductor compound can be selected from the group consisting of a binary compound selected from the group consisting of SnS, SnSe, SnTe, PbS, PbSe, PbTe, and a mixture thereof; a ternary compound selected from the group consisting of SnSeS, SnSeTe, SnSTe, PbSeS, PbSeTe, PbSTe, SnPbS, SnPbSe, SnPbTe, and a mixture thereof; and a quaternary compound selected from the group consisting of SnPbSSe, SnPbSeTe, SnPbSTe, and a mixture thereof.

The IV element or the compound containing the IV element can be selected from the group consisting of an element compound selected from the group consisting of Si, Ge, and a mixture thereof; and a binary compound selected from the group consisting of SiC, SiGe, and a mixture thereof.

The quantum dot can have a homogeneous single structure; a dual structure such as a core-shell structure or a gradient structure; and a mixed structure thereof.

In the core-shell double structure, a substance constituting each a core and a shell can be formed of the semiconductor compounds different from each other as described above. For example, the core can contain one or more substances selected from the group consisting of CdSe, CdS, ZnS, ZnSe, ZnTe, CdTe, CdSeTe, CdZnS, PbSe, AgInZnS, HgS, HgSe, HgTe, GaN, GaP, GaAs, InP, InAs, and ZnO, and but is not limited thereto. For example, the shell can contain one or more substances selected from the group consisting of CdSe, ZnSe, ZnS, ZnTe, CdTe, PbS, TiO, SrSe, and HgSe, but is not limited thereto.

From the viewpoint of obtaining white light, the quantum dot is preferably InP or CdSe.

A diameter of the quantum dot is not particularly limited, but red, green, and blue quantum dot particles can be classified by a particle diameter, and the particle diameter decreases in the order of red, green, and blue. Specifically, the red quantum dot particle may have a particle diameter of 5 nm or more and 10 nm or less, the green quantum dot particle may have a particle diameter of more than 3 nm and 5 nm or less, and the blue quantum dot particle may have a particle diameter of 1 nm or more and 3 nm or less. At the time of irradiation with light, the red quantum dot particles emit red light, the green quantum dot particles emit green light, and the blue quantum dot particles emit blue light.

The phosphor other than the phosphor of the present invention contained in the composition is not particularly limited, and examples thereof include a sulfide-based phosphor, an oxide-based phosphor, a nitride-based phosphor, and a fluoride-based phosphor. These phosphors may be used alone or in combination of two or more thereof.

Examples of the sulfide-based phosphor include CaS:Eu, SrS: Eu, SrGa₂S₄:Eu, CaGa₂S₄:Eu, Y₂O₂S:Eu, La₂O₂S:Eu, and Gd₂O₂S:Eu.

Specific examples of the oxide-based phosphor include (Ba,Sr)₃SiO₅:Eu, (Ba,Sr)₂SiO₄:Eu, Tb₃Al₅O₁₂:Ce, and Ca₃Sc₂Si₃O₁₂:Ce.

Specific examples of the nitride-based phosphor include CaSi₅N₈:Eu, Sr₂Si₅N₈:Eu, Ba₂Si₅N₈:Eu, (Ca,Sr,Ba)₂Si₅N₈:Eu, Cax(Al,Si)₁₂(O,N)₁₆:Eu (0 < x ≤ 1.5), CaSi₂O₂N₂:Eu, SrSi₂O₂N₂:Eu, BaSi₂O₂N₂:Eu, (Ca,Sr,Ba) Si₂O₂N₂:Eu, CaAl₂Si₄N₈:Eu, CaSiN₂:Eu, CaAlSiN₃:Eu, and (Sr,Ca)AlSiN₃:Eu.

Specific examples of the fluoride-based phosphor are not particularly limited, and include K₂TiF₆:Mn⁴⁺, Ba₂TiF₆:Mn⁴⁺, Na₂TiF₆:Mn⁴⁺, K₃ZrF₇:Mn⁴⁺, and K₂SiF₆:Mn⁴⁺.

Specific examples of the other phosphors are not particularly limited, and include a YAG-based phosphor such as (Y,Gd)₃(Al,Ga)₅O₁₂:Ce(YAG:Ce); a sialon-based phosphor such as Lu(Si,Al)₁₂(O,N)₁₆:Eu, and a perovskite phosphor having a perovskite structure.

The phosphor other than the phosphor of the present invention contained in the composition is preferably a red phosphor, and is preferably K₂SiF₆:Mn⁴⁺, from the viewpoint of obtaining white light.

A proportion of the light emitting material other than the phosphor of the present invention contained in the composition is not particularly limited, and is 0.1 wt% or more and 90 wt% or less, preferably 1 wt% or more and 80 wt% or less, and more preferably 5 wt% or more and 60 wt% or less.

### <Film>

The phosphor of the present invention can be dispersed in a resin and used as a film shape. The film shape is not particularly limited, and may be any shape such as a sheet shape or a bar shape. In the present specification, the "bar-like shape" means, for example, a belt-like shape in a plan view extending in one direction. Examples of the belt-like shape in a plan view include a plate-like shape in which lengths of the respective sides are different. A thickness of the film may be 0.01 um to 1,000 mm, 0.1 µm to 10 mm, or 1 um to 1 mm. In the present specification, the thickness of the film refers to a distance between a front surface and a back surface of the film in a thickness direction when a side having the smallest value among the length, width, and height of the film is defined as the "thickness direction". Specifically, the thickness of the film is measured at any three points of the film using a micrometer, and an average value of the measured values at the three points is taken as the thickness of the film. In addition, the film may be a single layer or a multi-layer. In the case of the multi-layer, each layer may be formed of the same type of compositions of the embodiment, or may be formed of different types of compositions of the embodiment.

### <Sintered Body>

The phosphor of the present invention can be used as a sintered body containing the phosphor of the present invention by being contained in an inorganic material and being sintered and formed. The inorganic material used for the sintered body may be a glass molded body using a glass component, or may be a crystalline inorganic material component.

### <Glass Molded Body>

The phosphor of the present invention can be dispersed in glass and used as a glass molded body. The glass component used in the glass composition is not particularly limited, and examples thereof include SiO₂, P₂O₅, GeO₂, BeF₂, As₂S₃, SiSe₂, GeS₂, TiO₂, TeO₂, Al₂O₃, Bi₂O₃, V₂O₅, Sb₂O₅, PbO, CuO, ZrF₄, AlF₃, InF₃, ZnCl₂, ZnBr₂, Li₂O, Na₂O, K₂O, MgO, BaO, CaO, SrO, LiCl, BaCl, BaF₂, and LaF₃. Among them, SiO₂ or Bi₂O₃ is preferably contained as a glass component from the viewpoint of improving durability, heat resistance, and light resistance. The glass component may be one kind or two or more kinds.

A proportion of the glass component contained in the glass molded body is not particularly limited, and is 10 wt% or more and 99 wt% or less, preferably 20 wt% or more and 80 wt% or less, and more preferably 30 wt% or more and 70 wt% or less.

The glass molded body may contain a light scattering material from the viewpoint of scattering light passing through the molded body, improving the amount of light absorbed by the molded body, and improving the light emission intensity. As the light scattering material, the same inorganic fine particles as those of the light scattering material used for the resin composition can be used.

The amount of the light scattering material added to the glass molded body can be the same as the amount of the light scattering material used for the resin composition.

The glass molded body may contain an additional light emitting material other than the phosphor of the present invention from the viewpoint of adjusting the color of light emitted by the glass molded body and achieving a high color gamut. As the additional light emitting material other than the phosphor of the present invention contained in the glass molded body, the same light emitting material as that used for the resin composition can be used.

The amount of the light emitting material added to the glass molded body can be the same as the amount of the light emitting material used for the resin composition.

The shape of the glass molded body is not particularly limited, and examples thereof include a plate shape, a rod shape, a cylindrical shape, and a wheel shape.

### <Light Emitting Element>

The phosphor of the present invention can constitute a light emitting element together with a light source. As the light source, in particular, an LED that emits ultraviolet light or visible light having a wavelength of 350 nm to 500 nm can be used. When the phosphor of the present invention is irradiated with light having the wavelength described above, the phosphor emits green light having a peak at a wavelength of 510 nm to 550 nm. Therefore, in the phosphor of the present invention, for example, an ultraviolet LED or a blue LED is used as a light source, and the phosphor can be combined with other red phosphors to form a white light emitting element.

### <Light Emitting Device>

The phosphor of the present invention can constitute a white light emitting element as described above, and the white light emitting element can be used as a member of a light emitting device. In the light emitting device, a light emitting element is irradiated with light from a light source, and the irradiated light emitting element emits light to extract the light.

### <Display>

The light emitting element including the phosphor of the present invention and the light source can be used for a display. Examples of such a display include a liquid crystal display capable of controlling a transmittance of light derived from a light emitting element with liquid crystals and selecting and extracting transmitted light as red light, blue light, and green light by a color filter.

### <Phosphor Wheel>

The phosphor of the present invention can be used for manufacturing a phosphor wheel. The phosphor wheel is a member having a disk-like substrate and a phosphor layer formed on a surface of the substrate. The phosphor wheel absorbs excitation light emitted from the light source, excites the excitation light, and emits converted light having different wavelengths. For example, the phosphor wheel can absorb blue excitation light, emit converted light different from the blue excitation light converted by the phosphor layer, and reflect the blue excitation light to be converted into light of various colors in conjunction with the converted light or utilizing only the converted light.

### <Projector>

The phosphor of the present invention can be used as a member constituting a projector using the phosphor wheel. The projector is a display device including a light source, a phosphor wheel, a mirror device, and a projection optical system.

### EXAMPLES

Hereinafter, the present invention will be described in more detail with reference to Examples. The present invention is not limited to these Examples.

### <Example 1>

An aluminum oxide powder (grade: AA-03 (purity: 99.99%, D50: 0.40 µm, specific surface area: 5.6 m²/g), manufactured by Sumitomo Chemical Co., Ltd.), a magnesium oxide powder (MgO (purity: 4 N), manufactured by Kanto Chemical Co., Inc.), and a manganese carbonate powder (MnCO₃ (purity: 99.9%), manufactured by Sigma-Aldrich Japan K.K.) were used as raw materials of a crystal phase of a phosphor, and each raw material was weighed so that a composition of the phosphor after firing had a molar ratio of Mn:Mg:Al:O = 0.05:0.95:2:4 in consideration of desorption of carbonic acid in manganese carbonate as carbon dioxide (CO₂) after firing. Next, as a raw material of a shell part, boron oxide (B₂O₃ (purity: 99.995%), manufactured by Kojundo Chemical Lab. Co., Ltd.) was weighed in an amount of 1 wt% of the raw materials of the crystal phase, the weighed raw material was added to the raw materials of the crystal phase, and then dry-mixing was performed for 3 minutes. Next, an alumina container was filled with the mixed raw material. Subsequently, the alumina container was set in an electric furnace, and a mixed gas of hydrogen:nitrogen = 10:90 was introduced. The temperature was raised to 1,550°C, heating was performed for 4 hours, and then it was allowed to cool. The heated product was recovered from the container and crushed to obtain a phosphor.

### <Example 2>

A phosphor was produced in the same manner as that of Example 1, except that the amount of boron oxide used was changed to 5 wt% of the raw materials of the crystal phase.

### <Example 3>

A phosphor was produced in the same manner as that of Example 1, except that an aluminum oxide powder of grade: AA-3 (purity: 99.99%, D50: 3.5 µm, specific surface area: 0.6 m²/g) was used instead of the aluminum oxide powder of grade: AA-03.

### <Example 4>

A phosphor was produced in the same manner as that of Example 1, except that the amount of boron oxide used was changed to 5 wt% of the raw materials of the crystal phase, and an aluminum oxide powder of grade: AA-3 (purity: 99.99%, D50: 3.5 µm, specific surface area: 0.6 m²/g) was used instead of the aluminum oxide powder of grade: AA-03.

### <Example 5>

A phosphor was produced in the same manner as that of Example 1, except that glass frit (grade: CF0055, manufactured by Takara Standard Co., Ltd.) was used instead of boron oxide in an amount of 5 wt% of the raw materials of the crystal phase, and an aluminum oxide powder of grade: AA-3 (purity: 99.99%, D50: 3.5 um, specific surface area: 0.6 m²/g) was used instead of the aluminum oxide powder of grade: AA-03.

### <Example 6>

A phosphor was produced in the same manner as that of Example 1, except that an aluminum oxide powder of grade: AA-18 (purity: 99.99%, D50: 20.3 um, specific surface area: 0.2 m²/g) was used instead of the aluminum oxide powder of grade: AA-03.

### <Example 7>

A phosphor was produced in the same manner as that of Example 1, except that the amount of boron oxide used was changed to 5 wt% of the raw materials of the crystal phase, and an aluminum oxide powder of grade: AA-18 (purity: 99.99%, D50: 20.3 um, specific surface area: 0.2 m²/g) was used instead of the aluminum oxide powder of grade: AA-03.

### <Comparative Example 1>

A phosphor was produced in the same manner as that of Example 1, except that the amount of boron oxide used was changed to 0.01 wt% of the raw materials of the crystal phase, and an aluminum oxide powder of grade: AKP-700 (purity: 99.99%, D50: 0.1 um, specific surface area: 17.8 m²/g) was used instead of the aluminum oxide powder of grade: AA-03.

### <Comparative Example 2>

A phosphor was produced in the same manner as that of Example 1, except that the amount of boron oxide used was changed to 0.02 wt% of the raw materials of the crystal phase, and an aluminum oxide powder of grade: A-210 (purity: 99.7%, D50: 95 µm, specific surface area: 0.5 m²/g) was used instead of the aluminum oxide powder of grade: AA-03.

### <Various Measurements and Evaluations>

The following items were measured for the phosphors produced in Examples and Comparative Examples.

### (a) Crystal Structure

Powder X-ray diffraction using CuK_{α} rays was performed on the phosphors of Examples and Comparative Examples using an X-ray diffractometer ("X'Pert Pro" (trade name) manufactured by Malvern Panalytical Ltd.). It was confirmed from the obtained X-ray diffraction pattern that the same diffraction pattern as that of the spinel-type crystal structure was observed, and the main crystal phase had the same crystal structure as the spinel-type crystal structure.

### (b) Average Size of Crystallite

Each of the phosphors of Examples and Comparative Examples was processed by a focused ion beam (FIB) processing apparatus ("FB-2200" (trade name), manufactured by Hitachi High-Technologies Corporation) to obtain a cross section of the phosphor. The processed sample was placed on a grid dedicated to a transmission electron microscope (TEM), and the obtained cross section of the phosphor was observed using a TEM ("JEM-2200FS" (trade name), manufactured by JEOL Ltd.) at an acceleration voltage of 200 kV. The field of view and magnification were appropriately adjusted to acquire a TEM image, and as necessary, an electron diffraction (ED) pattern and an element mapping image by energy dispersive X-ray spectroscopy (EDX) ("JED-2300" (trade name), manufactured by JEOL Ltd.) were obtained. The obtained TEM image was taken into a computer, and an equivalent circle diameter was calculated by area weighted average for each of the observed crystallites. Image analysis software "Image J" was used to calculate the equivalent circle diameter. 50 or more crystallites were analyzed, and an average circle equivalent diameter as the average value thereof was taken as an average size of the crystallites.

### (c) Ratio of Peak Area Value of Each Element Present in Shell Part

The phosphors of Examples and Comparative Examples were mixed with an epoxy resin obtained by mixing a main agent (EpoxiCure 2 Resin, manufactured by Buehler) and a curing agent (EpoxiCure 2 Hardener, manufactured by Buehler) at a ratio of 4:1, and the mixture was dried in the air for one day to obtain a molded body. The obtained molded body was processed with an ion milling apparatus ("IM 4000" (trade name), manufactured by Hitachi High-Technologies Corporation) to obtain a cross section of a phosphor. The obtained cross section of the phosphor was observed at an acceleration voltage of 20 kV using a scanning electron microscope (SEM) ("S-4800" (trade name), manufactured by Hitachi High-Technologies Corporation). The field of view and magnification were appropriately adjusted to obtain an element mapping image by windowless EDX ("X-max 80" (trade name) manufactured by Oxford Instruments plc). From the element mapping image obtained by the above method, it was found that there were a core part formed of a crystal phase and a shell part in which manganese and boron or silicon coexisted. From the results of EDX measurement, a ratio (Y/X) of a peak area value Y of boron or silicon to a peak area value X of manganese present in the shell part was calculated for more than 20 shell parts, and an average value was calculated. In manganese, two points of 5.66 keV and 6.15 keV were set as points at which peaks rose, and among these two points, a point with low intensity was set as 0, peaks were integrated between the two points, and the integrated value was taken as a peak area value of manganese. In boron, two points of 0.14 keV and 0.23 keV were set as points at which peaks rose, and among these two points, a point with low intensity was set as 0, peaks were integrated between the two points, and the integrated value was taken as a peak area value of boron. In silicon, two points of 1.60 keV and 1.95 keV were set as points at which peaks rose, and among these two points, a point with low intensity was set as 0, peaks were integrated between the two points, and the integrated value was taken as a peak area value of silicon.

### (d) Particle diameter distribution

Particle diameter distributions of the phosphors of Examples and Comparative Examples were measured using a laser diffraction particle diameter analyzer ("Mastersizer 2000" (trade name), aqueous solvent, manufactured by Malvern Panalytical Ltd.) to determine a central particle diameter (that is, D50).

### (e) Light Emission Intensity

Light emission spectra of the phosphors of Examples and Comparative Examples were measured using an absolute PL quantum yield measuring apparatus ("C9920-02" (trade name), manufactured by Hamamatsu Photonics K.K.). For the measurement, a glass petri dish was filled with the powder, and a light emission spectrum was measured at an excitation wavelength of 450 nm. It was confirmed that all the phosphors were green light emitting phosphors. A method for evaluating the light emission intensity is described below.

An area value of a light emission peak was calculated from the obtained light emission spectrum, the calculated area value was converted into a percentage with an area value at a light emission peak of the phosphor of Example 1 as 100%, and relative light emission intensity was calculated. The relative light emission intensity of each phosphor was evaluated on the basis of whether or not it was at a level that can be used for a light emitting element. That is, a phosphor having an evaluation of 44 or more has relative light emission intensity at a level that can be used for a light emitting element.

The measurement results and evaluation results of Examples and Comparative Examples are shown in Tables 1 and 2.

**[Table 1]**

| | Example 1 | Example 2 | Example 3 | Example 4 | Example 5 | Example 6 |
|---|---|---|---|---|---|---|
| Grade of aluminum oxide powder | AA-03 | AA-03 | AA-3 | AA-3 | AA-3 | AA-18 |
| D50 of aluminum oxide powder (µm) | 0.40 | 0.40 | 3.5 | 3.5 | 3.5 | 20.3 |
| Specific surface area of aluminum oxide powder (m²/g) | 5.6 | 5.6 | 0.6 | 0.6 | 0.6 | 0.2 |
| Amount of B₂O₃ used (wt%) | 1 | 5 | 1 | 5 | 0 | 1 |
| Amount of glass frit used (wt%) | 0 | 0 | 0 | 0 | 5 | 0 |
| Average size of crystallites (µm) | - | 14.33 | - | 5.56 | - | - |
| D50 of phosphor (µm) | 26 | - | 31 | - | 59 | 29 |
| Y/X | - | 0.040 | - | 0.037 | - | - |
| Light emission intensity | 100 | 94 | 64 | 100 | 55 | 62 |

**[Table 2]**

| | Example 7 | Comparative Example 1 | Comparative Example 2 |
|---|---|---|---|
| Grade of aluminum oxide powder | AA-18 | AKP-700 | A-210 |
| D50 of aluminum oxide powder (µm) | 20.3 | 0.1 | 95 |
| Specific surface area of aluminum oxide powder (m²/g) | 0.2 | 17.8 | 0.5 |
| Amount of B₂O₃ used (wt%) | 5 | 0.01 | 0.02 |
| Amount of glass frit used (wt%) | 0 | 0 | 0 |
| Average size of crystallites (µm) | 18.75 | 1.97 | 1.22 |
| D50 of phosphor (µm) | - | - | - |
| Y/X | 0.048 | 0 | 0 |
| Light emission intensity | 78 | 39 | 43 |

From Tables 1 and 2, it can be seen that the larger the average size of the crystallites is, the better the light emission intensity of the phosphor is. In addition, it can be seen that the light emission intensity of the phosphor has no correlation with D50 of the phosphor.

### <Example 8>

An aluminum oxide powder (grade: AA-03 (purity: 99.99%, D50: 0.40 µm, specific surface area: 5.6 m²/g), manufactured by Sumitomo Chemical Co., Ltd.), a magnesium oxide powder (MgO (purity: 4 N), manufactured by Kanto Chemical Co., Inc.), a manganese carbonate powder (MnCOs (purity: 99.9%), manufactured by Sigma-Aldrich Japan K.K.), and aluminum nitride (manufactured by Tokuyama Corporation) were used as raw materials of a crystal phase of a phosphor, and each raw material was weighed so that a composition of the phosphor after firing had a molar ratio of Mn:Mg:Al:O:N = 0.05:0.95:2:3.997:0.002 in consideration of desorption of carbonic acid in manganese carbonate as carbon dioxide (CO₂) after firing. Next, as a raw material of a shell part, boron oxide (B₂O₃ (purity: 99.995%), manufactured by Kojundo Chemical Lab. Co., Ltd.) was weighed in an amount of 5 wt% of the raw materials of the crystal phase, the weighed raw material was added to the raw materials of the crystal phase, and then dry-mixing was performed for 3 minutes. Next, an alumina container was filled with the mixed raw material. Subsequently, the alumina container was set in an electric furnace, and a mixed gas of hydrogen:nitrogen = 10:90 was introduced. The temperature was raised to 1,550°C, heating was performed for 4 hours, and then it was allowed to cool. The heated product was recovered from the container and crushed to obtain a phosphor.

The items (a) to (e) were measured or evaluated for the obtained phosphor. The results are shown in Table 3.

### (a) Crystal Structure

It was confirmed from the measurement of the item (a) that, in Example 8, the same diffraction pattern as that of the spinel-type crystal structure was observed, and the main crystal phase had the same crystal structure as the spinel-type crystal structure.

### (e) Light Emission Intensity

It was confirmed from the measurement of the item (a) that Example 8 was a green light emitting phosphor.

**[Table 3]**

| | Example 8 |
|---|---|
| Grade of aluminum oxide powder | AA-03 |
| D50 of aluminum oxide powder (um) | 0.40 |
| Specific surface area of aluminum oxide powder (m²/g) | 5.6 |
| Amount of B₂O₃ used (wt%) | 5 |
| Amount of glass frit used (wt%) | 0 |
| Average size of crystallites (um) | 15.1 |
| D50 of phosphor (um) | - |
| Y/X | 0.04 |
| Light emission intensity | 99 |

### <Example 9>

As a raw material of a crystal phase of a phosphor, a β-sialon phosphor powder (D50: 15.8 um, manufactured by Sialon Co., Ltd.) was prepared. It was confirmed that the element composition of the sialon powder was Eu:Si:Al:O:N = 0.02:5.8:0.2:0.2:7.8 by analysis using a fluorescent X-ray spectrometer ("ZSX Primus II" (trade name), manufactured by Rigaku Corporation) and an oxygen/nitrogen analyzer ("EMGA-920" (trade name), manufactured by HORIBA, Ltd.).

Next, as raw materials of a shell part, boron oxide (B₂O₃ (purity: 99.995%), manufactured by Kojundo Chemical Lab. Co., Ltd.) and europium oxide (Eu₂O₃ (purity: 99.9%), manufactured by Kojundo Chemical Lab. Co., Ltd.) were weighed in amounts of 5 wt% and 1 wt% of the raw material of the crystal phase, respectively, the weighed raw materials were added to the raw material of the crystal phase, and then dry-mixing was performed for 3 minutes. Next, an alumina container was filled with the mixed raw material. Subsequently, the alumina container was set in an electric furnace, and a mixed gas of hydrogen:nitrogen = 10:90 was introduced. The temperature was raised to 1,550°C, heating was performed for 4 hours, and then it was allowed to cool. The heated product was recovered from the container and crushed to obtain a phosphor.

The items (a) to (e) were measured or evaluated for the obtained phosphor. The results are shown in Table 4.

### <Comparative Example 3>

The crystallite size of the β-sialon phosphor powder used in Example 9 was reduced to obtain a β-sialon phosphor powder of D50: 0.78 um. A phosphor was produced in the same manner as that of Example 9 except for using the β-sialon phosphor powder, and the items (a) to (e) were measured or evaluated. The results are shown in Table 4.

### (a) Crystal Structure

It was confirmed from the measurement of the item (a) that, in Example 9 and Comparative Example 3, the same diffraction pattern as that of the β-sialon structure was observed, and the main crystal phase had the same crystal structure as the β-sialon structure.

### (e) Light Emission Intensity

It was confirmed from the measurement of the item (a) that Example 9 and Comparative Example 3 were green light emitting phosphors.

An area value of a light emission peak was calculated from the obtained light emission spectrum, the calculated area value was converted into a percentage with an area value at a light emission peak of the phosphor of Example 9 as 100%, and relative light emission intensity was calculated. The relative light emission intensity of each phosphor was evaluated on the basis of whether or not it was at a level that can be used for a light emitting element. That is, a phosphor having an evaluation of 44 or more has relative light emission intensity at a level that can be used for a light emitting element.

**[Table 4]**

| | Example 9 | Comparative Example 3 |
|---|---|---|
| Composition of raw material containing Al | SiAlON | SiAlON |
| D50 of raw material containing Al (µm) | 15.8 | 0.78 |
| Specific surface area of raw material containing Al (m²/g) | - | - |
| Amount of B₂O₃ used (wt%) | 5 | 5 |
| Amount of glass frit used (wt%) | 0 | 0 |
| Average size of crystallites (µm) | 15.5 | 0.68 |
| D50 of phosphor (µm) | - | - |
| Y/X | - | - |
| Light emission intensity | 100 | 2 |

### <Reference Example 1>

The phosphor described in each of Examples 1 to 9 was combined with a resin, sealed in a glass tube or the like, and then disposed between a blue light emitting diode as a light source and a light guide plate, thereby manufacturing a backlight capable of converting blue light of the blue light emitting diode into green light or red light.

### <Reference Example 2>

The phosphor described in each of Examples 1 to 9 was combined with a resin to obtain a sheet-like resin, and a sealed film obtained by sandwiching the sheet-like resin between two barrier films on the top of a light guide plate, thereby manufacturing a backlight capable of converting blue light emitted from a blue light emitting diode placed on an end surface (side surface) of the light guide plate to the sheet through the light guide plate into green light or red light.

### <Reference Example 3>

The phosphor described in each of Examples 1 to 9 was disposed in the vicinity of a light emitting unit of a blue light emitting diode to manufacture a backlight capable of converting blue light to be radiated into green light and red light.

### <Reference Example 4>

A wavelength conversion material can be obtained by mixing the phosphor described in each of Examples 1 to 9 with a resist and then removing a solvent. The obtained wavelength conversion material was disposed between the blue light emitting diode as a light source and the light guide plate or at a subsequent stage of an OLED as a light source to manufacture a backlight capable of converting blue light of the light source into green light or red light.

### <Reference Example 5>

The phosphor described in each of Examples 1 to 9 was mixed with conductive particles such as ZnS to form a film, an n-type transport layer was laminated on one surface, and a p-type transport layer was laminated on the other surface, thereby obtaining an LED. When a current flows, holes of a p-type semiconductor and electrons of an n-type semiconductor cancel charges in a perovskite compound of a junction surface, such that light can be emitted.

### <Reference Example 6>

A titanium oxide dense layer was laminated on a surface of a fluorine-doped tin oxide (FTO) substrate, a porous aluminum oxide layer was laminated thereon, the phosphor described in each of Examples 1 to 9 was laminated thereon, a solvent was removed, and then a hole transport layer such as 2,2',7,7'-tetrakis-(N,N'-di-p-methoxyphenylamine)-9,9'-spirobifluorene (Spiro-OMeTAD) was laminated on the top thereof, and a silver (Ag) layer was laminated thereon, thereby manufacturing a solar cell.

### <Reference Example 7>

The phosphor described in each of Examples 1 to 9 was combined with a resin to form the composition of the present embodiment, and the composition was disposed at a subsequent stage of a blue light emitting diode, thereby manufacturing a laser diode lighting that converts blue light radiated to the composition from the blue light emitting diode into green light or red light and emits white light.

### <Reference Example 8>

The composition of the present embodiment was obtained by combining the phosphor described in each of Examples 1 to 9 with a resin and molding the composite. By using the obtained composition as a part of a photoelectric conversion layer, a photoelectric conversion element (photodetection element) material that is used in a detection portion detecting light is manufactured. The photoelectric conversion element material is used for an image detection unit (image sensor) for a solid-state imaging device such as an X-ray imaging device or a CMOS image sensor, a detection unit that detects a predetermined feature of a part of a living body, such as a fingerprint detection unit, a face detection unit, a vein detection unit, or an iris detection unit, and an optical biosensor such as a pulse oximeter.

### <Reference Example 9>

The composition of the present embodiment was obtained by combining the phosphor described in each of Examples 1 to 9 with a resin and molding the composite. The obtained composition can be used as a film for improving light conversion efficiency of a solar cell. The form of the conversion efficiency improvement sheet is not particularly limited, but the conversion efficiency improvement sheet is used by being applied to a base material. The base material is not particularly limited as long as it is a base material having high transparency. For example, a PET film, a moth-eye film, or the like is desirable. The solar cell using the solar cell conversion efficiency improvement sheet is not particularly limited, and the conversion efficiency improvement sheet has a conversion function from a wavelength region where the sensitivity of the solar cell is low to a wavelength region where the sensitivity is high.

### <Reference Example 10>

The composition of the present embodiment was obtained by combining the phosphor described in each of Examples 1 to 9 with a resin and molding the composite. The obtained composition can be used as a light source for single photon generation such as a quantum computer, quantum teleportation, and quantum cryptographic communication.

## Claims

1. A phosphor comprising a crystal phase of an aluminate compound containing a metal element M constituting a luminescent center ion and aluminum,
wherein the crystal phase contains crystallites, and
an average size of the crystallites is 2 to 100 µm.

2. The phosphor according to claim 1, wherein the aluminate compound has an element composition represented by Formula:
MₓMgₐSi_{b}Al_{y}O_{z}N_{w} (1)
[in Formula (1), M represents at least one metal element selected from the group consisting of manganese, strontium, cerium, praseodymium, neodymium, samarium, europium, gadolinium, terbium, dysprosium, thulium, and ytterbium, x is 0.001 ≤ x ≤ 0.3, a is 0 ≤ a ≤ 1.0 - x, b is 0 ≤ b ≤ 6.0, y is 0 ≤ y ≤ 11.3, z is 0 ≤ z ≤ 18, and w is 0 ≤ w ≤ 8.0].

3. The phosphor according to claim 1 or 2, wherein the aluminate compound is a magnesia-alumina spinel compound having an element composition represented by Formula:
MₓMgₐAl_{y}O_{z}N_{w} (2)
[in Formula (2), M represents at least one metal element selected from the group consisting of manganese, strontium, cerium, praseodymium, neodymium, samarium, europium, gadolinium, terbium, dysprosium, thulium, and ytterbium, x is 0.001 ≤ x ≤ 0.3, a is 0 ≤ a ≤ 1.0 - x, y is 1.2 ≤ y ≤ 11.3, z is 2.8 ≤ z ≤ 18, and w is 0 ≤ w ≤ 1.0].

4. The phosphor according to claim 1 or 2, wherein the aluminate compound is a β-sialon phosphor having an element composition represented by Formula:
MᵤSi₆₋ᵥAlᵥOᵥN₈₋ᵥ (4)
[in Formula (4), M represents at least one metal element selected from the group consisting of manganese, cerium, praseodymium, neodymium, samarium, europium, gadolinium, terbium, dysprosium, thulium, and ytterbium, u is 0.001 ≤ u ≤ 0.3, and v is 0 < v < 4.2].

5. The phosphor according to any one of claims 1 to 4, wherein the metal element M constituting the luminescent center ion represents at least one metal element selected from the group consisting of manganese, strontium, europium, and terbium.

6. The phosphor according to claim 2, wherein x is 0.001 ≤ x ≤ 0.15, a is 0 ≤ a ≤ 0.95, b is 0 ≤ b ≤ 6.0, y is 0 ≤ y ≤ 2.5, z is 0 ≤ z ≤ 4.5, and w is 0 ≤ w ≤ 1.0.

7. The phosphor according to claim 3, wherein x is 0.05 ≤ x ≤ 0.15, a is 0 ≤ a ≤ 0.95, y is 1.5 ≤ y ≤ 2.5, z is 3.5 ≤ z ≤ 4.5, and w is 0 ≤ w ≤ 1.0.

8. The phosphor according to claim 4, wherein u is 0.001 ≤ u ≤ 0.02, and v is 0.005 ≤ v ≤ 1.0.

9. The phosphor according to claim 3 or 7, wherein the crystallites have a spinel-type crystal structure.

10. The phosphor according to any one of claims 1 to 9, wherein the phosphor includes:
a core part formed of the crystal phase; and
a shell part containing at least one element selected from the group consisting of boron and silicon and formed on at least a portion of a surface of the core part.

11. A film comprising the phosphor according to any one of claims 1 to 10.

12. A light emitting element comprising the phosphor according to any one of claims 1 to 10.

13. A light emitting device comprising the light emitting element according to claim 12.

14. A display comprising the light emitting element according to claim 12.

15. A sintered body comprising the phosphor according to any one of claims 1 to 10.

16. A phosphor wheel comprising the phosphor according to any one of claims 1 to 10.

17. A projector using the phosphor wheel according to claim 16.
